(19)

Europäisches
Patentamt
European
Patent Office
Office européen
des brevets

(11) **EP 1 841 076 A1**

(12) **EUROPEAN PATENT APPLICATION**

(43) Date of publication:
**03.10.2007 Bulletin 2007/40**

(51) Int Cl.:
*H03M 13/23* (2006.01)      *H03M 13/27* (2006.01)
*H03M 13/29* (2006.01)      *H03M 13/45* (2006.01)

(21) Application number: **07014100.7**

(22) Date of filing: **11.05.2001**

(84) Designated Contracting States:
**DE ES**

(30) Priority: **22.05.2000 JP 2000150535**

(62) Document number(s) of the earlier application(s) in
accordance with Art. 76 EPC:
**01930077.1 / 1 292 037**

(71) Applicant: **MITSUBISHI DENKI KABUSHIKI
KAISHA
Chiyoda-ku, Tokyo 100-8310 (JP)**

(72) Inventor: **Matsumoto, Wataru
Chiyoda-ku, Tokyo 100-8310 (JP)**

(74) Representative: **Pfenning, Meinig & Partner GbR
Patent- und Rechtsanwälte
Theresienhöhe 13
80339 München (DE)**

Remarks:
This application was filed on 18 - 07 - 2007 as a
divisional application to the application mentioned
under INID code 62.

(54) **Method of and device for communication**

(57)      A turbo encoder (1) includes an interleaver (32, 33) which stores 289-bit information bit sequences in an input buffer of 17 (abscissa M: prime number) x 17 (ordinate N: natural number), generates random sequences of 16 types by shifting a specific 16-bit random sequence generated by using the prime number bit by bit in units of rows, maps information bit sequences of an interleave length (289 bits) on the 17 (M) x 17 (N) mapping pattern generated from the random sequences of 16 types, and reads the mapped information bit sequences in units of columns.

# FIG.1

**Description**

TECHNICAL FIELD

The present invention relates to a communication device which employs a multi-carrier modulation/demodulation scheme. More particularly, this invention relates to a method of and device for communication which make it possible to realize data communication using a known communication line by a DMT (Discrete Multi Tone) modulation/demodulation scheme, an OFDM (Orthogonal Frequency Division Multiplex) modulation/demodulation scheme, or the like. The present invention can be applied to not only a communication device for performing data communication by the DMT modulation/demodulation scheme, but also all communication devices for performing wire communication and wireless communication by a multi-carrier modulation/demodulation scheme and a single-carrier modulation/demodulation scheme.

BACKGROUND ART

A conventional communication device will be described below. For example, in a wide band CDMA (W-CDMA: Code Division Multiple Access) using an SS (Spread Spectrum) scheme, as an error correction code the performance of which is considerably higher than the performance of a convolutional code, a turbo code is proposed. This turbo code codes a sequence obtained by performing interleave to an information bit sequence in parallel to a known coded sequence. It is said that the turbo code can obtain characteristics which are close to the Shannon limit. The turbo code is one of error correction codes which maximally attract attention at present. In the W-CDMA, since transmission characteristics in audio transmission or data transmission are considerably dependent on the performance of the error correction code, the transmission characteristics can be considerably improved by applying the turbo code.

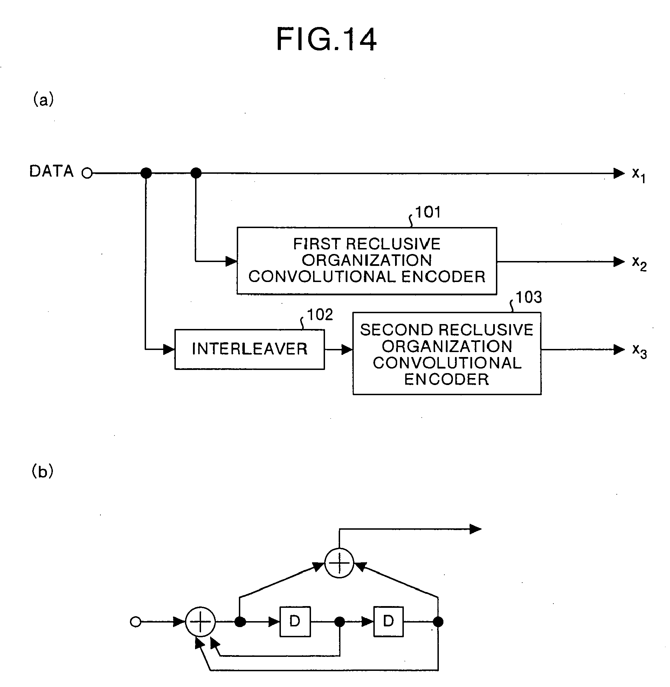

The operations of a transmission system and a reception system in a conventional communication device using the turbo code will be described below. Fig. 14 includes diagrams showing the configurations of a turbo encoder used in a transmission system. In Fig. 14(a), reference numeral 101 denotes a first reclusive organization convolutional encoder for convolutionally encoding an information bit sequence to output a redundant bit, reference numeral 102 denotes an interleaver, and reference numeral 103 denotes a second reclusive organization convolutional encoder for convolutionally encoding an information bit sequence after replacement by the interleaver 102 to output a redundant bit. Fig. 14(b) is a diagram showing the internal configuration of the first reclusive organization convolutional encoder 101 and the second reclusive organization convolutional encoder 103. The two reclusive organization convolutional encoders are encoders for outputting only redundant bits, respectively. In the interleaver 102 used in the turbo encoder, the process of replacing information bit sequences at random is performed.

In the turbo encoder constituted as described above, an information bit sequence: $x_1$, redundant bit sequence: $x_2$ obtained by encoding the information bit sequence: $X_1$ by the process in the first reclusive organization convolutional encoder 101, and a redundant bit sequence: $x_3$ obtained by encoding an information bit sequence subj ected to an interleave process by the process of the second reclusive organization convolutional encoder 103 are output.

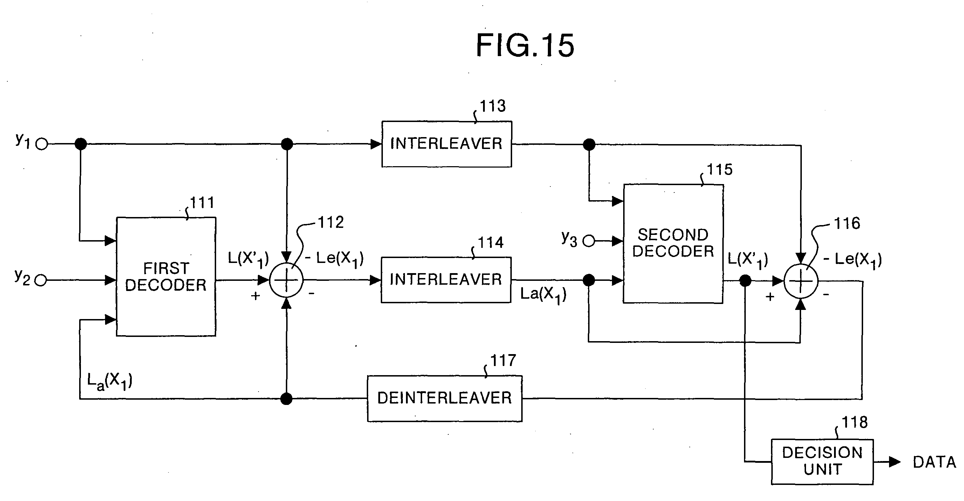

Fig. 15 is a block diagram showing the configuration of a turbo decoder used in a reception system. In Fig. 15, reference numeral 111 denotes a first decoder for calculating a logarithmic likelihood ratio from a reception signal: $y_1$ and a reception signal: $y_2$, reference numerals 112 and 116 denote adders, reference numerals 113 and 114 denote interleavers, reference numeral 115 denotes a second decoder for calculating a logarithmic likelihood ratio from the reception signal: $y_1$ and a reception signal $y_3$, reference numeral 117 denotes a deinterleaver, and reference numeral 118 denotes a decision unit for deciding an output from the second decoder 115 to output an estimated value of an original information bit sequence. The reception signals: $y_1$, $y_2$, and $y_3$ are signals obtained by giving the influences of noise and fading in a transmission path to the information bit sequence: $x_1$ and the redundant bit sequences: $x_2$ and $x_3$, respectively.

In the turbo decoder constituted as described above, the first decoder 111 calculates a logarithmic likelihood ratio: $Le(x_{1k}')$ (k represents time) of an estimated information bit: $x_{1k}'$ estimated from a reception signal: $Y_{1k}$ and a reception signal: $Y_{2k}$. In this case, a ratio of a probability that the information bit: $X_{1k}$ is 1 to a probability that the information bit: $X_{1k}$ is 0 is calculated. Reference symbol $Le(x_{1k})$ denotes external information, and reference symbol $La(x_{1k})$ denotes previous information which is previous external information.

In the adder 112, from the logarithmic likelihood ratio which is the calculation result, external information to the second decoder 115 is calculated. In the first decoding, since previous information is not calculated, $La(x_{1k})=0$ is established.

In the interleavers 113 and 114, in order to adjust the times of the reception signal: $y_{1k}$ and the external information $Le(x_{1k})$ to the time of the reception signal $y_3$, signals are rearranged. Thereafter, in the second decoder 115, as in the first decoder 111, a logarithmic likelihood ratio: $L(x_{1k}')$ is calculated on the basis of the reception signal: $y_1$, the reception signal $y_3$, and the external information $Le(x_{1k})$ which is calculated in advance. In an adder 116, the

external information Le ($x_{1k}$) is calculated. At this time, the pieces of external information which are rearranged in the deinterleaver 117 are fed back to the first decoder 111 as previous information La($x_{1k}$).

Finally, in this turbo decoder, the above process is repeatedly executed a predetermined number of times to calculate a logarithmic likelihood ratio having a higher accuracy. The decision unit 118 performs a decision on the basis of the logarithmic likelihood ratio, and estimates an original information bit sequence. More specifically, for example, when the logarithmic likelihood ratio satisfies "L($x_{1k}$') > 0, the estimated information bit: $x_{1k}$' is decided as 1. When "L ($x_{1k}$') ≤ 0" is satisfied, the estimated information bit: $x_{1k}$' is decided as 0.

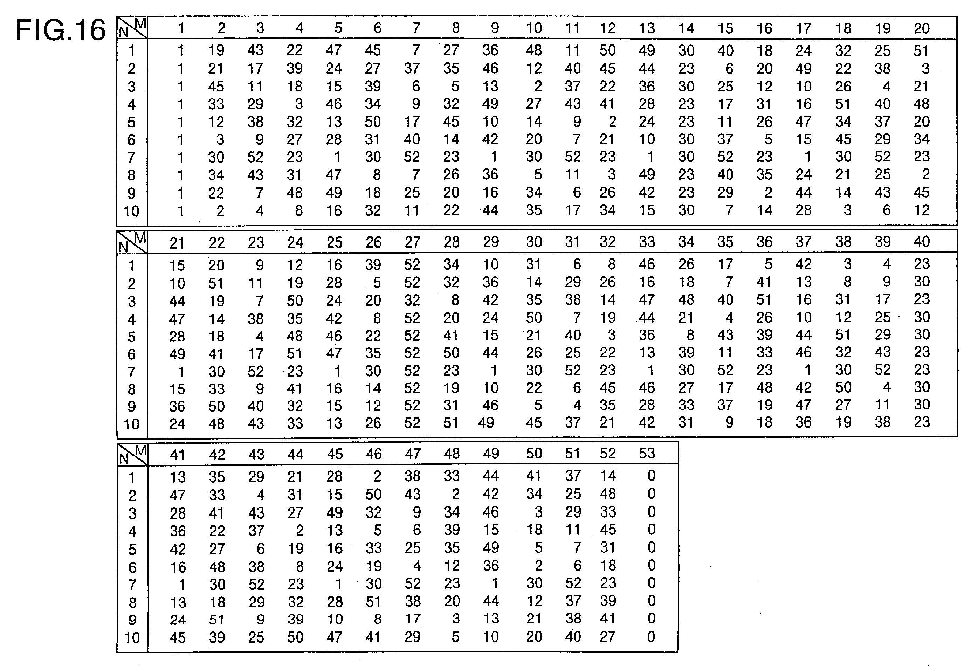

Figs. 16, 17, and 18 are tables showing a process of the interleaver 102 used in the turbo encoder. In this case, a process of replacing information bit sequences by the interleaver 102 will b described below.

For example, in the W-CDMA, as an interleaver, a complex interleaver (to be referred to as a PIL hereinafter) is generally used. This PIL has the following three characteristic features.

1. Replacement of columns and rows in N (ordinate: natural number) x M (abscissa: natural number) buffer is performed.
2. In replacement of bits in a row, a pseudo random pattern using a prime number is used.
3. A critical pattern is avoided by replacement of the rows.

In this case, an operation of the PIL serving as a conventional interleaver will be described below. For example, it is assumed that interleave length: $L_{turbo}$=512 bit, N=10, M=P=53 ($L_{turbo}$/N ≤ P+1) , and primitive root: $g_0$=2 are satisfied. In this case, a mapping pattern: c (i) is formed as described in equation (1) as follows:

$$c(i) = (g_0 \times c(i-1)) \bmod P \qquad \qquad ...(1)$$

where i=1, 2, ..., (P-2) and c(0)=1 are satisfied.

Therefore, the mapping pattern C(i) is {1, 2, 4, 8, 16, 32, 11, 22, 44, 35, 17, 34, 15, 30, 7, 14, 28, 3, 6, 12, 24, 48, 43, 33, 13, 26, 52, 51, 49, 45, 37, 21, 42, 31, 9, 18, 36, 19, 38, 23, 46, 39, 25, 50, 47, 41, 29, 5, 10, 20, 40, 27 } .

In the PIL, skipping is performed through the mapping pattern C(i) every skipping pattern: $P_{PIP(j)}$ to replace bits with each other, a mapping pattern: $C_j$(i) having j rows. In this case, in order to obtain $P_{PIP(j)}$, {$q_j$(j=0 to N -1) } is determined by the following equations (2), (3), and (4) :

$$q_0 = 1 \qquad \qquad ...(2)$$

$$g.c.d \{q_j, P-1\} = 1 \quad \text{(where the g.c.d is the greatest common divisor)} \qquad ...(3)$$

$$q_j > 6, \; q_j > q_{j-1} \quad \text{(where j=1 to N-1)} \qquad ...(4)$$

Therefore, {$q_j$} is [1, 7, 11, 13, 17, 19, 23, 29, 31, 37], and {$P_{pip(j)}$} is {37, 31, 29, 23, 19, 17, 13, 11, 7, 1} (where PIP=N-1 to 0).

Fig. 16 is a table showing a result obtained by skipping mapping patterns C (i) on the basis of the skipping pattern: $p_{PIP(j)}$, i.e., a result obtained by rearranging respective rows by using the skipping patterns.

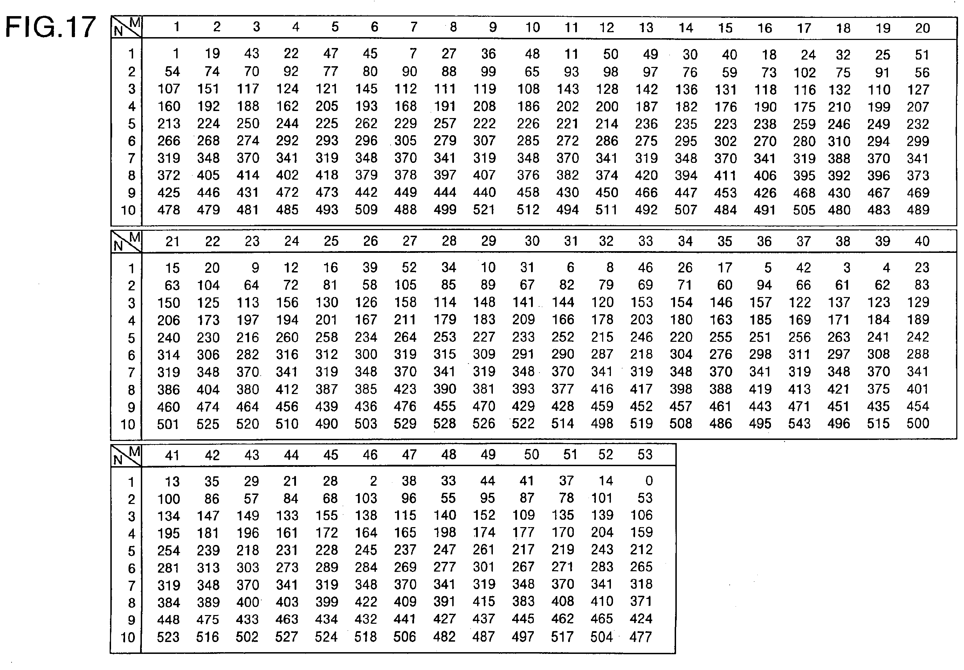

Fig. 17 is a table showing a data arrangement when data having an interleave length: $L_{turbo}$=512 bit are mapped on the mapping pattern after the rearrangement. In this case, data {0 to 52} is mapped on the first row, data {53 to 105} is mapped on the second row, data {106 to 158} is mapped on the third row, data {159 to 211} is mapped on the fourth row, data {212 to 264} is mapped on the fifth row, data {256 to 317} is mapped on the sixth row, data {318 to 370} is mapped on the seventh row, data {371 to 423} is mapped on the eighth row, data {424 to 476} is mapped on the ninth row, data {477 to 529} is mapped on the tenth row.

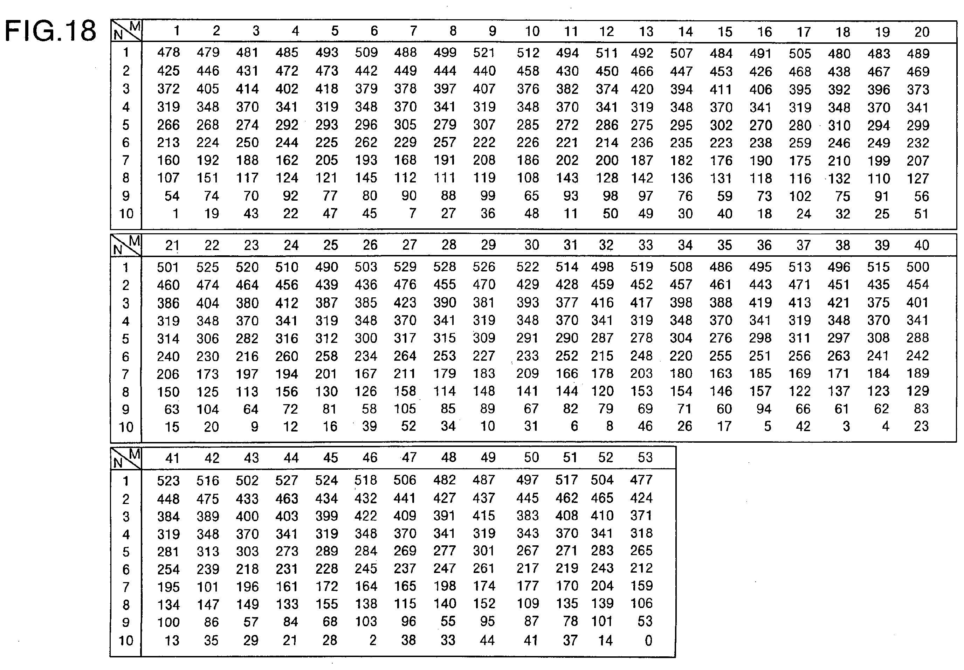

Finally, Fig. 18 is a table showing a final rearrangement pattern. In this case, replacement of rows as shown in the data arrangement shown in Fig. 18 is performed according to a predetermined rule to generate a final rearrangement pattern (in this case, the order of the rows is reversed). In the PIL, the generated rearrangement pattern is read in units of columns, i.e., in the longitudinal direction.

In this manner, when the PIL is used as an interleaver, a turbo code for generating a code word having a preferable weight distribution can be provided in a wide-range interleave length (for example, $L_{turbo}$=257 to 8192 bit) .

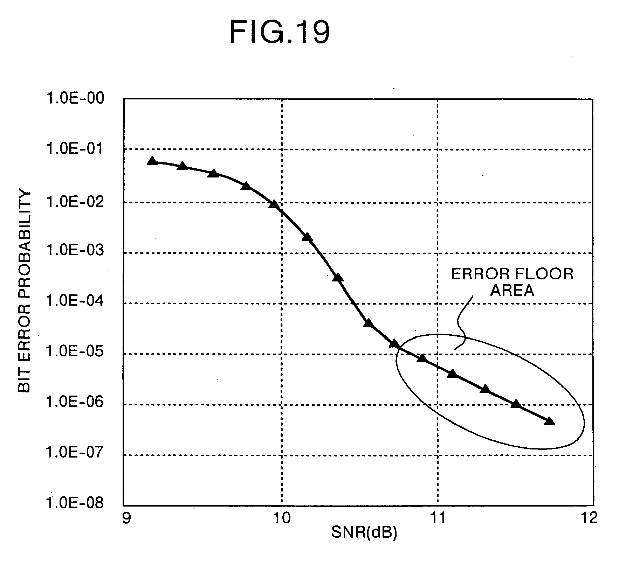

Fig. 19 is a graph showing BER (bit error rate) characteristics obtained when a conventional turbo encoder and a conventional turbo decoder including the PIL are used. As shown in Fig. 19, as the SNR increases, the BER characteristics are improved. For example, when the performance of a turbo code is decided by using a BER as shown in Fig. 19, "minimum humming weight: $W_{min}$" obtained after turbo encoding is performed influences the BER having a high SNR. More specifically, it is generally known that the BER in an error follower region (region in which the BER moderately falls) increases when the minimum humming weight is small.

The minimum humming weight is the minimum value of the number of '1' of the respective patterns which can be employed by the sequences ($X_1$, $X_2$, $X_3$) shown in Fig. 14. Therefore, for example, code words:

$x_1$=...00100100000...
$x_2$=...00010100000...
$x_3$=...00010101000...

are patterns each showing the minimum value of the number of '1', the minimum humming weight of the turbo encoder satisfies $2_{min}$=7 . In this expression, $X_1$ represents an input data sequence of the encoder, and $x_2$ and $x_3$ represent output data sequences from the encoder.

In this manner, in the conventional communication device, when the turbo code is applied as an error correction code, even though an inter-signal-point distance decreases according to multi-valuing of a modulation scheme, transmission characteristics in audio transmission or data transmission can be considerably improved, and characteristics which are better than those of a conventional convolutional code can be obtained.

In the conventional communication device, turbo encoding is performed to all input information sequences (all sequences when there are a plurality of information bit sequences), and all the encoded signals are turbo-decoded on the reception side. Thereafter, soft decision is performed. More specifically, for example, the decision is performed to all 4-bit data (0000 to 1111; 4-bit constellation) if 16 QAM is used and to all 8-bit data if 256 QAM is used.

However, in the above conventional communication device which employs the turbo code, for example, an encoder (corresponding to a reclusive organization convolutional encoder) and an interleaver which are used in the conventional turbo encoder shown in Fig. 14(b) have rooms for improvement. It cannot be said that the turbo encoder using the conventional encoder and the interleaver obtains optimum transmission characteristics which are close to the Shannon limit, i.e., optimum BER characteristics.

The conventional turbo encoder is specialized in one information bit sequence, but is not cope with two information bit sequences, disadvantageously.

It is an object of the present invention to provide a communication device and a communication method which can be applied to all communications using a multi-carrier modulation/demodulation scheme and a single-carrier modulation/demodulation scheme and which can realize an improvement of BER characteristics which is considerably higher than that of a prior art.

DISCLOSURE OF THE INVENTION

The communication device according to one aspect of the present invention comprises a turbo encoder having a first reclusive organization convolutional encoder for convolutionally encoding two information bit sequences to output first redundant data; a second reclusive organization convolutional encoder for convolutionally encoding the information bit sequences subjected to the interleave process to output second redundant data; and an interleaver. The interleaver stores the information bit sequences in an input buffer of "M (abscissa: prime number)=$2^m$+1" x "N (ordinate: natural number)=$2^m$" (m is an integer), generates random sequences of (M-1) types by shifting a random sequence of a specific (M-1) bit generated by using the prime number bit by bit in units of rows and maps minimum values at Mth bits of respective rows in all the random sequences and makes a mapping pattern of an Nth row equal to that of the first row to generate an M x N mapping pattern, maps information bit sequences of an interleave length on the M x N mapping pattern, and reads the mapped information bit sequences in units of columns to output the information bit sequences to the second reclusive organization convolutional encoder.

In the communication device according to the above-mentioned aspect, when the two information bit sequences are stored in the input buffer, the interleaver replaces at least one row such that an inter-signal-point distance of these information bit sequences is not 0.

In the communication device according to the above-mentioned aspect, the interleaver forms a latin square pattern in a buffer of (M-1) x (N-1) as random sequences of the (M-1) types.

In the communication device according to the above-mentioned aspect, the interleaver determines N to satisfy "N (ordinate: natural number) $\geq 2^m+1$".

In the communication device according to the above-mentioned aspect, the interleaver maps maximum values at the starts of all the rows in random sequences of the prime number (M-1), and makes a mapping pattern of an Nth row equal to a mapping pattern of the first row to generate an M x N mapping pattern.

The communication method according to still another aspect of this invention rearranges two information bit sequences in a turbo encoder. The communication method comprises: the bit sequence storing step of storing the information bit sequences in an input buffer of, "M (abscissa: prime number)=$2^m+1$" x "N (ordinate: natural number) =$2^m$"; the mapping pattern generation step of generating random sequences of (M-1) types by shifting a random sequence of a specific (M-1) bit generated by using the prime number bit by bit in units of rows, mapping minimum values at Mth bits of respective rows in all the random sequences, and making a mapping pattern of an Nth row equal to that of the first row to generate an M x N mapping pattern; the mapping step of mapping information bit sequences of an interleave length on the M x N mapping pattern; and the bit sequence read step of reading the mapped information bit sequences in units of columns.

In the communication method according to the above-mentioned aspect, in the bit sequence storing step, when the two information bit sequences are stored in the input buffer, at least one row is replaced such that an inter-signal-point distance of these information bit sequences is not 0.

In the communication method according to the above-mentioned aspect, in the mapping pattern generation step, a latin square pattern is formed in a buffer of (M-1) x (N-1) as random sequences of the (M-1) types.

A In the communication method according to the above-mentioned aspect, N is determined to satisfy "N (ordinate: natural number) $\geq 2^m+1$".

In the communication method according to the above-mentioned aspect, in the mapping pattern generation step, maximum values are mapped at the starts of all the rows in random sequences of the prime number (M-1), and a mapping pattern of an Nth row is made equal to a mapping pattern of the first row to generate an M x N mapping pattern.

BRIEF DESCRIPTION OF THE DRAWINGS

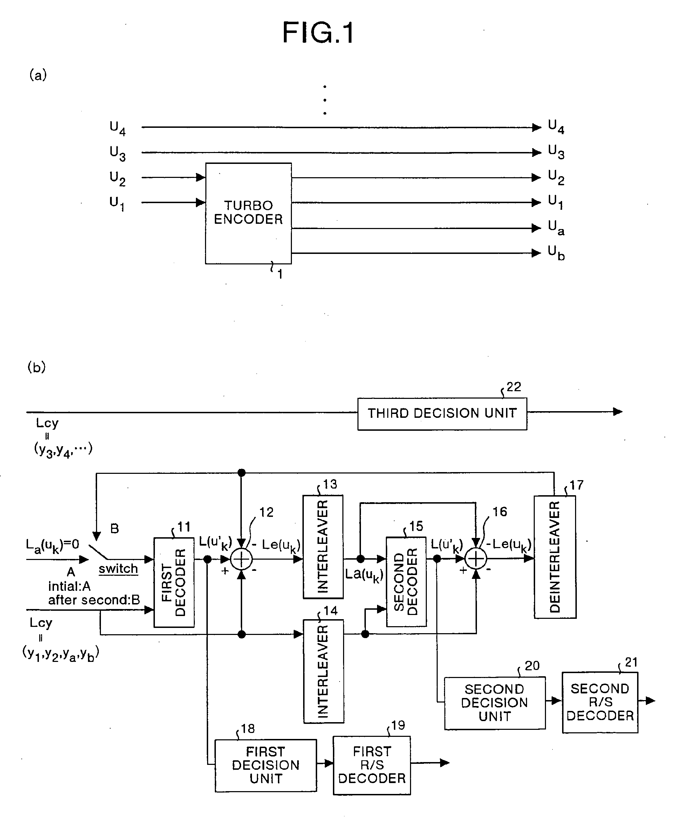

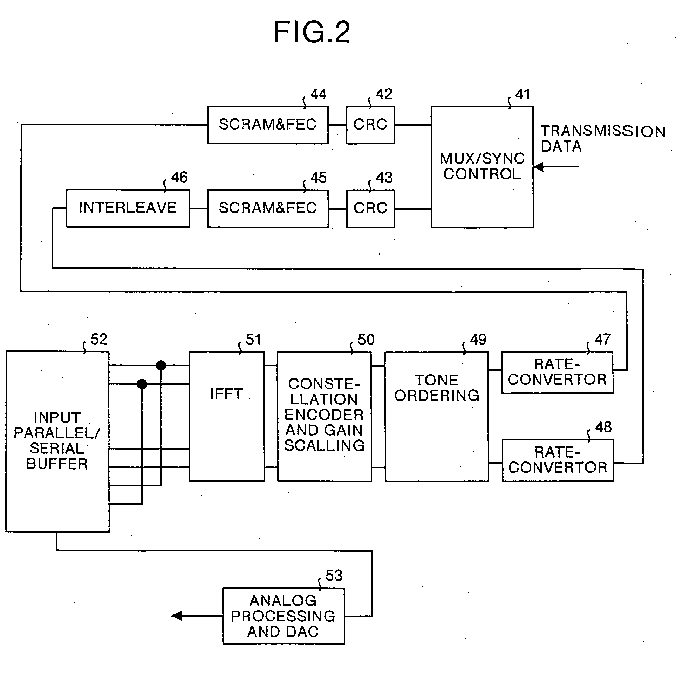

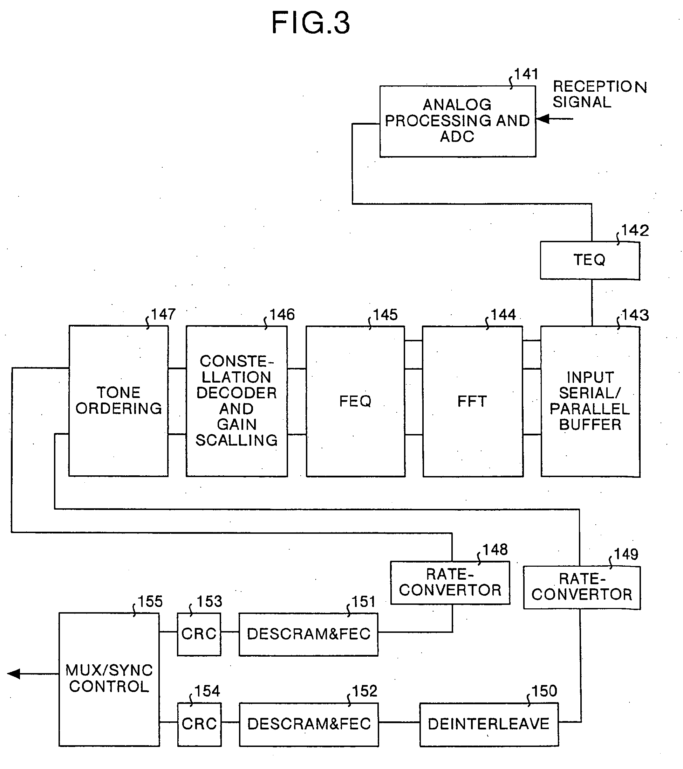

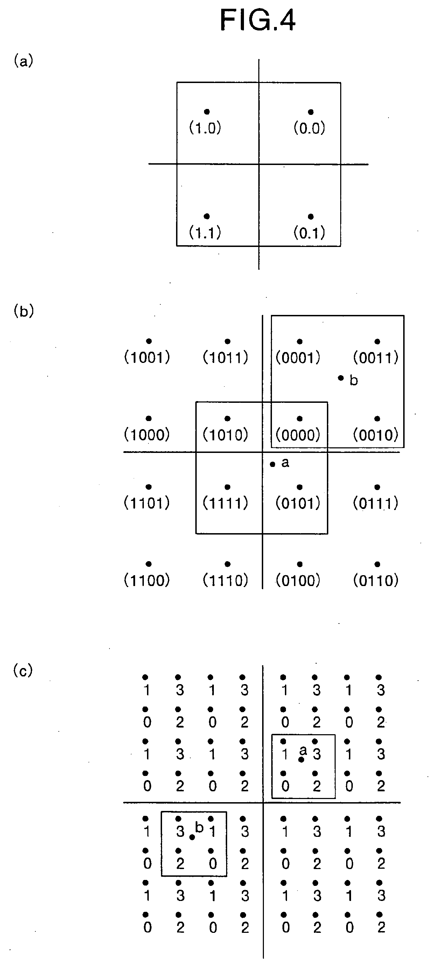

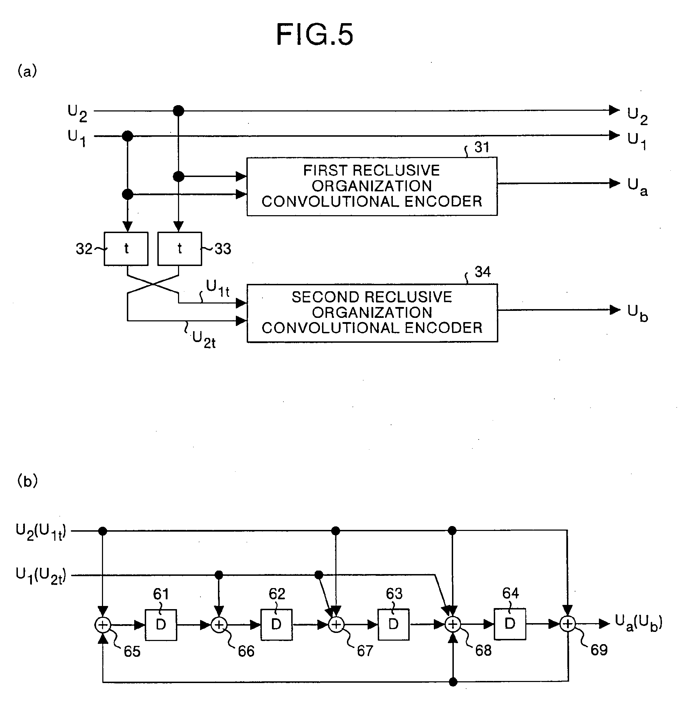

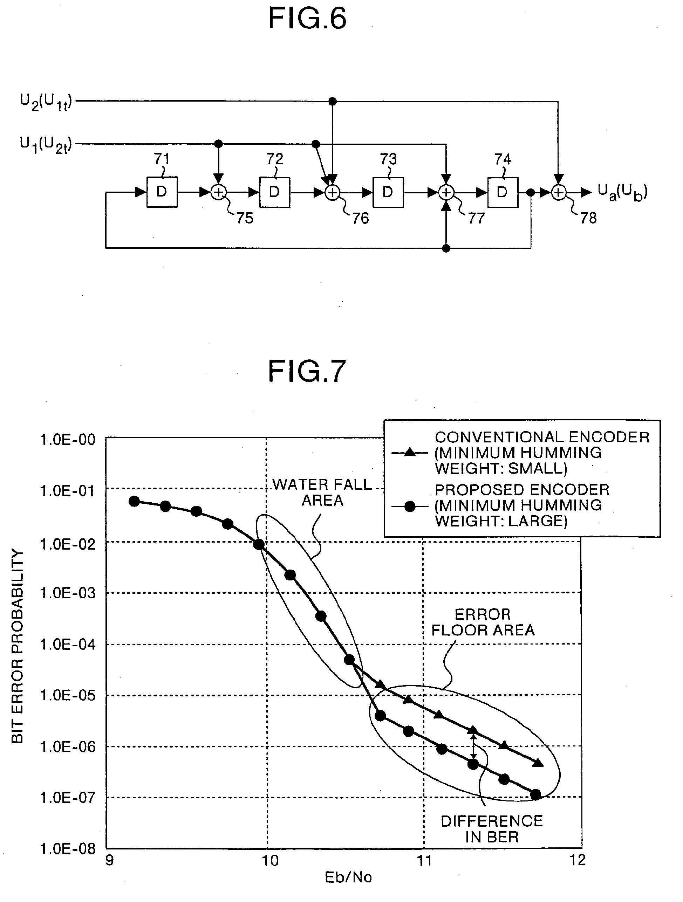

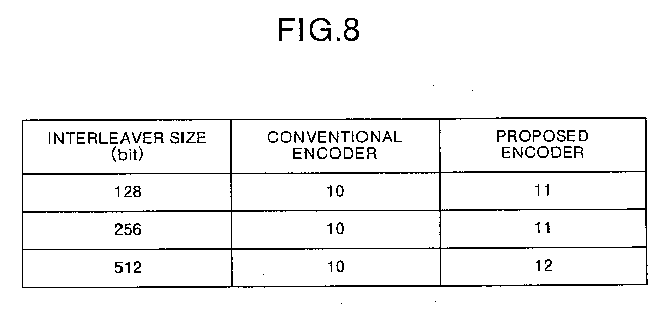

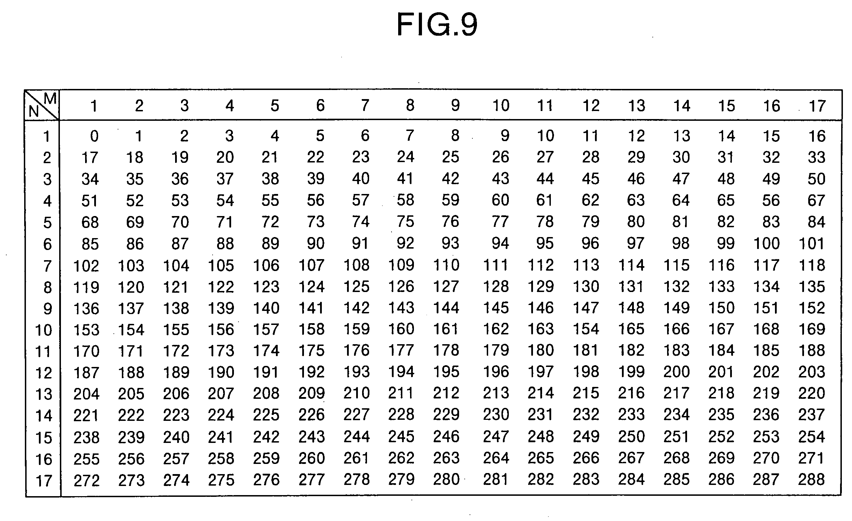

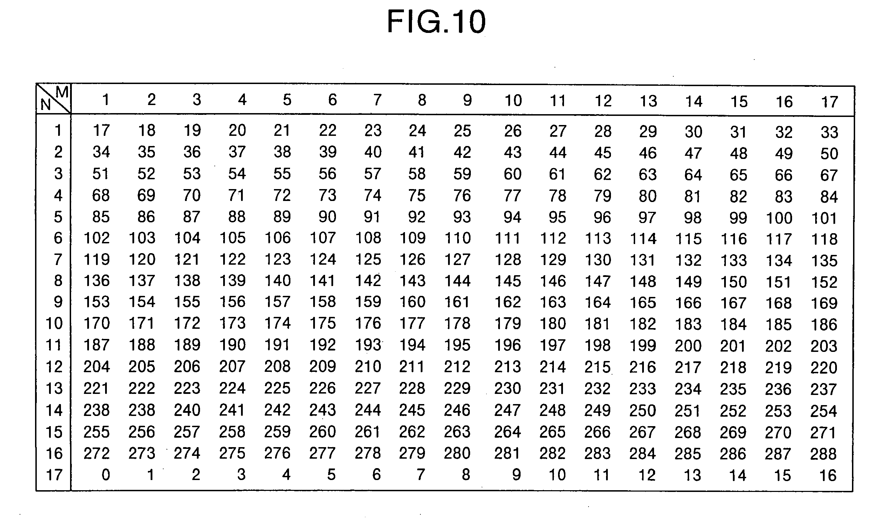

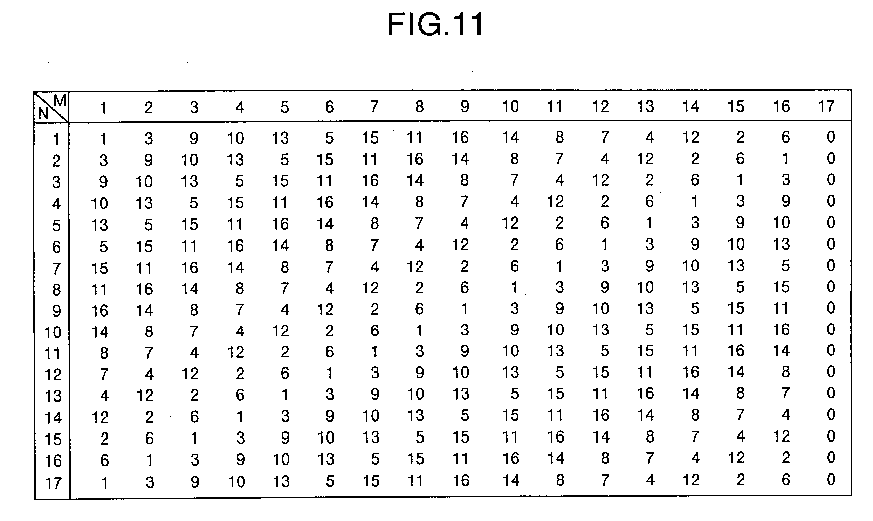

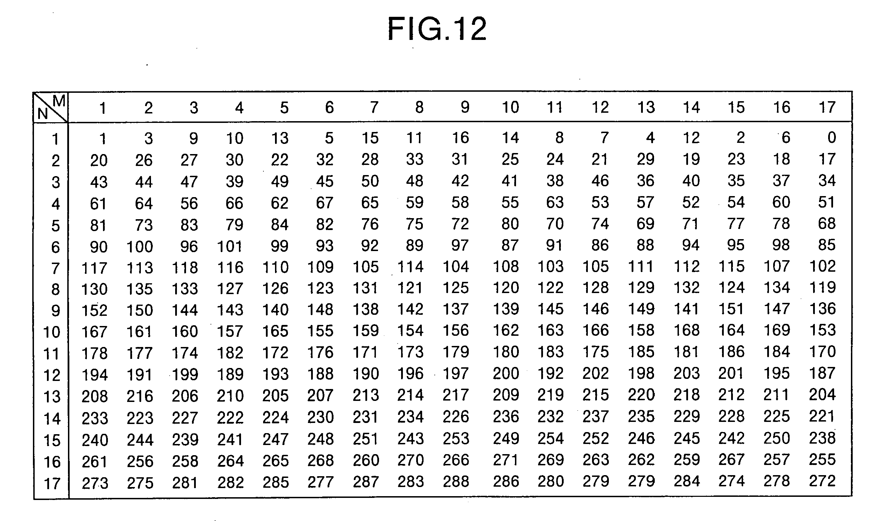

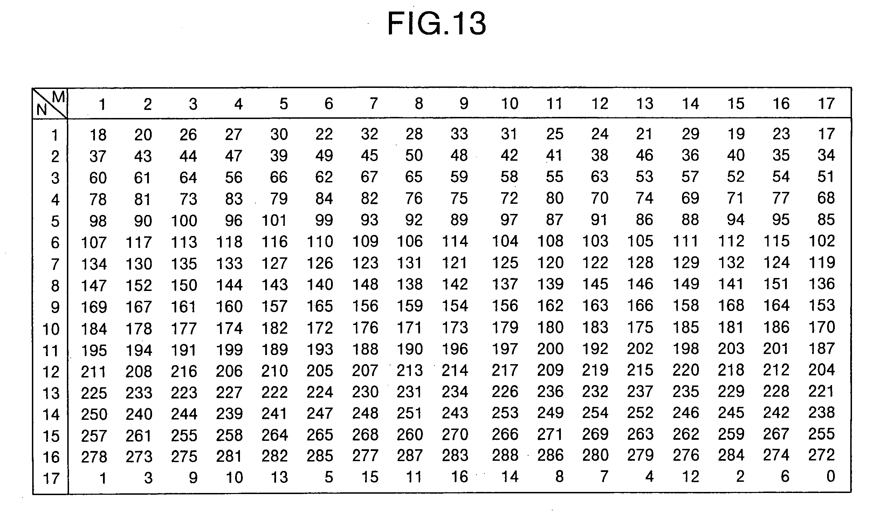

Fig. 1 includes diagrams showing the configurations of an encoder and a decoder which are used in a communication device according to the present invention; Fig. 2 is a diagram showing the configuration of a transmission system of the communication device according to the present invention; Fig. 3 is a diagram showing the configuration of a reception system of the communication device according to the present invention; Fig. 4 includes diagrams showing signal point arrangements of various digital modulations; Fig. 5 includes diagrams showing the configurations a turbo encoder; Fig. 6 is a diagram showing an example of a reclusive organization convolutional encoder constituting the same code as that of the reclusive organization convolutional encoder shown in Fig. 5 (b) ; Fig. 7 is a graph showing BER characteristics obtained when transmission data is decoded by the turbo encoder of the present invention and BER characteristics obtained when transmission data is decoded by using a conventional turbo encoder; Fig. 8 is a table showing a minimum humming weight of the turbo encoder of the present invention and a minimum humming weight in a conventional turbo encoder when a specific interleaver size is employed; Fig. 9 is a table showing an arrangement of u1 input buffers in an interleaver; Fig. 10 is a table showing an arrangement of u2 input buffers in the interleaver; Fig. 11 is a table showing a rearrangement pattern in units of rows; Fig. 12 is a table showing a data arrangement obtained when input data sequences: u1 in the rearrangement pattern; Fig. 13 is a table showing a data arrangement obtained when input data sequences: u2 in the rearrangement pattern; Fig. 14 includes diagrams showing the configuration of a conventional turbo encoder used in a transmission system; Fig. 15 is a diagram showing the configuration of the conventional turbo decoder used in a reception system; Fig. 16 is a table showing a process of the interleaver used in the conventional turbo encoder; Fig. 17 is a table showing a process of the interleaver used in the conventional turbo encoder; Fig. 18 is a table showing a process of the interleaver used in the conventional turbo encoder; and Fig. 19 is a graph showing bit error rate characteristics obtained when the conventional turbo encoder and the turbo decoder.

BEST MODE FOR CARRYING OUT THE INVENTION

Embodiments of a method of and device for communication according to the present invention will be described below with reference to the accompanying drawings. The present invention is not limited to these embodiments.

Fig. 1 includes diagrams showing the configuration of an encoder (turbo encoder) and a decoder (combination of a turbo decoder, a hard decision unit, and an R/S (Reed solomon code) decoder) used in a communication device according to the present invention. More specifically, Fig. 1(a) is a diagram showing the configuration of the encoder in this embodiment, and Fig. 1(b) is a diagram showing the configuration of the decoder in this embodiment.

The communication device according to this embodiment comprises the configurations of both the encoder and the decoder to have highly accurate data error correction capabilities, so that excellent transmission characteristics in data communication and audio communication. In this embodiment, for the sake of descriptive convenience, the communication device comprises both the configurations. However, for example, a transmitter comprising only the encoder of both the configurations may be supposed. On the other hand, a receiver comprising only the decoder may be supposed.

In the encoder shown in Fig. 1A, reference numeral 1 denotes a turbo encoder which can achieve a performance of almost shannon limit by employing turbo code as error correction code. For example, the turbo encoder 1 outputs information bit of two bits and redundant bit of two bits in response to input of information bit of two bits. Furthermore, in this case, each redundant bit is generated such that correction capability becomes uniform to each information bit on the reception side.

On the other hand, in the decoder in Fig. 1(b), reference numeral 11 denotes a first decoder for calculating a logarithmic likelihood ratio from reception signals: Lcy (corresponding to reception signals: $y_2$, $y_1$, and $y_a$ (to be described later)), reference numerals 12 and 16 denote adders, reference numerals 13 and 14 denote interleavers, reference numeral 15 denotes a second decoder for calculating a logarithmic likelihood ratio from reception signals: Lcy (corresponding to reception signals: $y_2$, $y_1$, and $y_b$ (to be described later), reference numeral 17 denotes a deinterleaver, reference numeral 18 denotes a first decision unit for deciding an output from the first decoder 11 to output an estimation value of an original bit sequence, reference numeral 19 denotes a first R/S decoder for decoding a reed solomon code to output a highly accurate information bit sequence, reference numeral 20 denotes a second decision unit for deciding an output from the second decoder 15 to output an estimation value of an original information bit sequence, reference numeral 21 denotes a second R/S decoder for decoding the reed solomon code to output a more accurate information bit sequence, and reference numeral 22 denotes a third decision unit for hard-deciding Lcy (corresponding to reception signals: $y_3$, $y_4$, ... , (to be described later) to output an estimation value of an original information bit sequence.

Before the encoder and the decoder are explained, the basic operation of the communication device according to the present invention will be briefly described below with reference to the drawings. For example, as a wire digital communication scheme for performing data communication by using a DMT (Discrete Multi Tone) modulation/demodulation scheme, an xDSL communication schemes such as an ADSL (Asymmetric Digital Subscriber Line) communication scheme for performing high-speed digital communication at several megabit/second by using a conventional telephone line or an HDSL (high-bit-rate Digital Subscriber Line) communication scheme is known. The scheme is standardized in ANSI T1 . 413 or the like. In the following description of this embodiment, it is assumed that a communication device which can be applied to the ADSL is used.

Fig. 2 is a diagram showing the configuration of a transmission system of the communication device according to the present invention. In Fig. 2, in the transmission system,transmission dataismultiplexed by a multiplex/sync control (corresponding to an MUX/SYNC CONTROL shown in Fig. 2) 41, error correction codes are added to the multiplexed transmission data by cyclic redundancy checks (corresponding to CRC: Cyclic redundancy checks) 42 and 43, and addition of FEC codes and a scramble process are performed by forward error corrections (corresponding to SCRAM & FEC) 44 and 45.

Two paths are formed between the multiplex/sync control 41 and a tone ordering 49. One is an interleaved data buffer (Interleaved Data Buffer) path including an interleaver (INTERLEAVE) 46, the other is a fast data buffer (Fast Data Buffer) path which does not include an interleave. In this case, delay is large in the interleaved data buffer for performing an interleave process.

Thereafter, the transmission data is subjected to a rate convert process by rate converters (corresponding to RATE-CONVERTER) 47 and 48, and is subjected to a tone ordering process by a tone ordering (corresponding to TONE ORDERING) 49. On the basis of the transmission data subjected to the tone ordering process, constellation data is formed in a constellation and gain scaling (corresponding to CONSTELLATION AND GAIN SCALING) 50, and inverse fast Fourier transform is performed in a inverse fast Fourier transform (corresponding to IFFT: Inverse Fast Fourier transform) 51.

Finally, the Fourier-transformed parallel data is converted into serial data in an input parallel/serial buffer (corresponding to INPUT/PARALLEL/SERIAL BUFFER 52, and the serial data is converted from a digital waveform into an analog waveform in an analog processing and DAC (corresponding to ANALOG PROCESSING AND DAC) 53. A filtering process is executed, and transmission data is transmitted onto a telephone line.

Fig. 3 is a diagram showing the configuration of the reception system of the communication device according to the present invention. In Fig. 3, in the reception system, a filtering process is executed to a reception data (the above transmission data) in an analog processing and ADC (corresponding to ANALOG PROCESSING AND ADC shown in Fig. 3) 141, and a time region is adaptive equalizing process of a time domain is performed in a time domain equalizer 142.

Data to which the adaptive equalizing process of a time domain is executed is converted from serial data to parallel data in an input serial/parallel buffer (corresponding to INPUT SERIAL/PARALLEL BUFFER) 143. Fast Fourier transform is performed to the parallel data in a fast Fourier transformer (corresponding to FFT : Fast Fourier transform) 144. Thereafter, an adaptive equalizing process of a frequency domain is performed in a frequency domain equalizer (corresponding to FEQ) 145.

The data to which the adaptive equalizing process of the frequency domain is converted into serial data by a decoding process (maximum likelihood decoding method) and a tone ordering process performed in a constellation decoder/gain scaling (corresponding to CONSTELLATION DECODER AND GAIN SCALING) 146 and a tone ordering (corresponding to TONE ORDERING) 147. Thereafter, processes such as a rate convert process performed by rate converters (corresponding to RATE-CONVERTER) 148 and 149, a deinterleave process performed by a deinterleave (corresponding to DEINTERLEAVE) 150, an FFC process and a descramble process performed by the forward error corrections (corresponding to DESCRAM & FEC) 151 and 152, and a cyclic redundancy check performed by cyclic redundancy checks (corresponding to cyclic redundancy check) 153 and 154 are performed. Finally, reception data is reproduced from a multiplex/sync control (MUX/SYNC CONTROL) 155.

In the communication device described above, each of the reception system and the transmission system has two paths, and the two paths are selectively used, or the two paths are simultaneously operated, so that a small transmission delay and high-rate data communication can be realized.

In the communication device constituted as described above, the encoder shown in Fig. 1(a) is located at the constellation and gain scaling 50, and the decoder shown in Fig. 1(b) is located at the constellation decoder/gain scaling 146 in the reception section.

Operations of the encoder (transmission system) and the decoder (reception system) according to this embodiment will be described below with reference to the drawings. The operation of the encoder shown in Fig. 1 (a) will be described first. In this embodiment, as multi-valued quadrature amplitude modulation (QAM: Quadrature Amplitude Modulation), a 16 QAM scheme is employed. In the encoder according to this embodiment, unlike a conventional technique in which turbo encoding is executed to all input data (4 bits), as shown in Fig. 1(a), turbo encoding is executed to only input data of lower two bits, and the input data of the other upper bits are directly output without being changed.

The reason why the turbo encoding is executed to the input data of the lower two bits will be described below. Fig. 4 includes diagrams showing signal point arrangements of various digital modulations. More specifically, Fig. 4 (a) shows a signal point arrangement of a 4-phase PSK (Phase Shift Keying) scheme, Fig. 4(b) shows a signal point arrangement of a 16 QAM scheme, and Fig. 4 (c) shows a signal point arrangement of a 64 QAM scheme.

For example, in the signal point arrangements of all the modulation schemes, when a reception signal point is located at a position a or b, most reliable data is estimated as an information bit sequence (transmission data) by soft decision on the reception side. More specifically, a signal point which is closest to the reception signal point is decided as transmission data. However, at this time, for example, when the reception signal points a and b shown in Fig. 4 are observed, in any cases (corresponding to Figs. 4 (a), 4 (b) , and 4 (c) ), it is understood that the lower two bits of four points which are closest to the reception signal point are (0, 0), (0, 1), (1, 0), and (1,1), respectively. In this embodiment, turbo encoding having excellent error correction capability is performed to the lower two bits of the four signals (i.e., the four points each having the smallest inter-signal distance) the characteristics of which may be deteriorated, and soft decision is performed on the reception side. On the other hand, the other upper bits the characteristics of which are rarely deteriorated are output without any changes, and hard decision is performed on the reception side.

In this manner, in this embodiment, the characteristics which may be deteriorated with multi-valuing can be improved. In addition, turbo encoding is performed to only the lower two bits of the transmission signals, an amount of calculation can be made considerably smaller than that of a conventional technique in which turbo encoding is performed to all bits.

Subsequently, an operation of the turbo encoder 1, shown in Fig. 1(a), for performing turbo encoding to transmission data: $u_1$ and $u_2$ of the input lower two bits. For example, Fig. 5 includes diagrams showing the configuration of the turbo encoder 1. More specifically, Fig. 5 (a) is a diagram showing the block diagram of the turbo encoder 1, and Fig. 5(b) is a diagram showing an example of the circuit configuration of a reclusive organization convolutional encoder. In this case, as the reclusive organization convolutional encoder, the configuration shown in Fig. 5(b). However, the reclusive organization convolutional encoder is not limited to the configuration. For example, the same reclusive organization convolutional encoder as a conventional reclusive organization convolutional encoder or another reclusive organization convolutional encoder may be used.

In Fig. 5(a), reference numeral 31 denotes a first reclusive organization convolutional encoder for convolutionally encoding transmission data: $u_1$ and $u_2$ corresponding to information bit sequences to output redundant data: $u_a$, reference numerals 32 and 33 denote interleavers, reference numeral 34 denotes a second reclusive organization convolutional encoder for convolutionally encoding data: $u_{1t}$ and $u_{2t}$ subjected to the interleave process to output a redundant data: $u_b$. In the turbo encoder 1, at the same time, the transmission data: $u_1$ and $u_2$, the redundant data: $u_a$ obtained by encoding the transmission data: $u_1$ and $u_2$ by the process of the first reclusive organization convolutional encoder 31, and the redundant data: $u_b$ (the time of which is different from that of the other data) obtained by encoding the data: $u_{lt}$ and $U_{2t}$ subjected to the interleave process by the process of the second reclusive organization convolutional encoder 34.

In the reclusive organization convolutional encoder shown in Fig. 5(b), reference numerals 61, 62, 63, and 64 denote delay units, and reference numerals 65, 66, 67, 68, and 69 denote adders. In this reclusive organization convolutional encoder, the first adder 65 adds the input transmission data: $u_2$ (or the data: $u_{1t}$) and the fed back redundant data: $u_a$ (or the data: $u_b$) to each other to output the resultant data, and the second adder 66 adds the input transmission data: $u_1$ (or the data: $u_{2t}$) and an output from the delay unit 61 to output the resultant data, the third adder 67 adds the input transmission data: $u_1$ (or the data: $u_{2t}$), the transmission data: $u_2$ (or the data: $u_{1t}$), and an output from the delay unit 62 to output the resultant data, the fourth adder 68 adds the input transmission data: $u_1$ (or the data: $u_{2t}$), the transmission data: $u_2$ (or the data: $u_{1t}$), an output from the delay unit 63, and the fed back redundant data: $u_a$ (or the redundant data: $u_b$), and the final adder 69 adds the input transmission data: $u_2$ (or the data: $u_{1t}$) and an output from the delay units 61, 62, 63, and 64 to finally output the redundant data: $u_a$ (redundant data: $U_b$)

In the turbo encoder 1, the weights of the redundant bits are prevented from being biased such that the estimation accuracies of the transmission data: $u_1$ and $u_2$ on the reception side using the redundant data: $u_a$ and $u_b$ are uniform. More specifically, in order to make the estimation accuracies of the transmission data: $u_1$ and $u_2$ uniform, for example, the transmission data: $u_2$ is input to the adders 65, 67, 68, and 69 (see Fig. 5 (b)) in the first reclusive organization convolutional encoder 31, and the data: $u_{2t}$ subjected to interleave is input to the adders 66 to 68 in the second reclusive organization convolutional encoder 34. On the other hand, the transmission data: $u_1$ is input to the adders 66 to 68 in the first reclusive organization convolutional encoder 31, and the data: $u_{1t}$ subjected to interleave is input to the adders 65, 67, 68, and 69 in the second reclusive organization convolutional encoder 34, so that the number of delay unit through which the sequence of the transmission data: $u_1$ passes until the sequence is output is equal to the number of delay unit through which the sequence of the transmission data: $u_2$ passes through the sequence is output.

In this manner, when the encoder shown in Fig. 1 (a), as the effect of interleave, an error correction capability for an error of burst data can be improved. In addition, the input of the sequence of the transmission data: $u_1$ and the input of the sequence of the transmission data: $u_2$ are switched between the first reclusive organization convolutional encoder 31 and the second reclusive organization convolutional encoder 34, so that the estimation accuracies of the transmission data: $u_1$ and $u_2$ on the reception side can be made equal to each other.

Fig. 6 is a diagram showing an example of a reclusive organization convolutional encoder having the same reference symbols as those of the reclusive organization convolutional encoder shown in Fig. 5 (b) . Therefore, when the reclusive organization convolutional encoder shown in Fig. 5 (b) is replaced with the circuit configuration shown in Fig. 6, the same effect as described above can be obtained.

In the reclusive organization convolutional encoder shown in Fig. 6, reference numerals 71, 72, 73, and 74 denote delay units, and reference numerals 75, 76, 77, and 78 denote adders. In this reclusive organization convolutional encoder, the first adder 75 adds the input transmission data: $u_1$ (or the data: $u_{2t}$) and an output from the delay unit 71 to each other to output the resultant data, and the second adder 76 adds the input transmission data: $u_1$ (or the data: $u_{2t}$) and an output from the delay unit 72 to output the resultant data, the third adder 77 adds the input transmission data: $u_1$ (or the data: $u_{2t}$), an output from the delay unit 73, and an fed back output from the delay unit 74 to output the resultant data, and the final adder 78 adds the input transmission data: $u_2$ (or the data: $u_{1t}$) and an output from the delay units 74 to finally output the redundant data: $u_a$ (redundant data: $u_b$).

An operation of the decoder shown in Fig. 1 (b) will be described below. In this embodiment, a case in which as multi-valued quadrature amplitude modulation (QAM), for example, the 16 QAM scheme is employed will be described below. In the decoder according to this embodiment, turbo decoding is performed to the lower two bits of reception data, and original transmission data is estimated by soft decision. With respect to the other upper bits, hard decision is performed to reception data by the third decision unit 22 to estimate original transmission data. Reception signals Lcy: $y_4$, $y_3$, $y_2$, $y_1$, $y_a$, and $y_b$ are signals obtained by giving the influence of noise or fading of a transmission path to outputs: $u_4$, $u_3$, $u_2$, $u_1$, $u_a$, and $u_b$ on the transmission side.

In a turbo decoder which receives the reception signals Lcy: $y_2$, $y_1$, $y_a$, and $y_b$, the first decoder 11 extracts the reception signals Lcy: $y_2$, $y_1$, and $y_a$ to calculate a logarithmic likelihood ratio: L ($u_{1k}'$) and L ($u_{2k}'$) of information bits (corresponding to the original transmission data: $u_{1k}$ and $u_{2k}$) : $u_{1k}'$ and $u_{2k}'$ estimated from these reception signals (k represents time). More specifically, the probability that $u_{2k}$ is 1 to the probability that $u_{2k}$ is 0 and the probability that $u_{1k}$ is 1 to the probability that $u_{1k}$ is 0 are calculated. In the following description, $u_{1k}$ and $u_{2k}$ are merely called $u_k$, and $u_{1k}'$ and $u_{2k}'$ are merely called $u_k'$ .

In Fig. (1b), Le ($U_k$) represents external information, and La($u_k$) represents previous information serving as previous external information. As a decoder for calculating a logarithmic likelihood ratio, a conventional maximum a-posteriori probability decoder (MAP algorithm: Maximum A-Posteriori) is frequently used. However, for example, a conventional viterbi decoder may be used.

In the adder 12, external information: Le ($u_k$) for the second decoder 15 is calculated from the logarithmic likelihood ratio which is the calculation result. Since the previous information is not calculated in the first decoding, La ($u_k$)=0 is satisfied.

In the interleavers 13 and 14, the reception signals: Lcy and the external information: Le($u_k$) are rearranged.

In the second decoder 15, as in the first decoder 11, the logarithmic likelihood ratio: $L(u_k')$ on the basis of the reception signals: Lcy and the previous information: $La(u_k)$ which is calculated in advance.

Thereafter, in the adder 16, as in the adder 12, the external information: $Le(u_k)$ is calculated. At this time, the external information which is rearranged by the deinterleaver 17 is fed back to the first decoder 11 as the previous information: $La(u_k)$.

In the turbo decoder, the process is repeatedly executed a predetermined number of times (iteration count) to calculate a logarithmic likelihood ratio having a higher accurate. The first decision unit 18 and the second decision unit 20 decide signals on the basis of the logarithmic likelihood ratio to estimate original transmission data. More specifically, for example, when the logarithmic likelihood ratio is "$L(u_k') > 0$", an estimation information bit: $u_k'$ is decided as 1. When "$L(u_k') \leq 0$" is satisfied, the estimation information bit: $u_k'$ is decided as 0. The reception signals Lcy: $y_3$, $y_4$,..., which are received at once are subjected to hard decision by using the third decision unit 22.

Finally, in the first R/S decoder 19 and the second R/S decoder 21, error check using a reed solomon code is performed by a predetermined method. The repeated process is ended when the estimation accuracy exceeds a specific reference. By using the reed solomon code, an error between the data estimated by the decision units and the transmission data is corrected, and the transmission data having a higher estimation accuracy is output.

Methods of estimating transmission data by the first R/S decoder 19 and the second R/S decoder 21 will be described below with reference to concrete examples. As the concrete examples, the following three methods are posed. As the first method, for example, each time original transmission data is estimated by the first decision unit 18 or the second decision unit 20, the corresponding first R/S decoder 19 or the corresponding second R/S decoder 21 alternately checks an error. When one of the R/S decoders decides that "there is no error", the repeated process performed by the turbo encoder is ended. Error correction of the estimated original transmission data is performed by using the reed solomon code, and the transmission data having a higher estimation accuracy is output.

As the second method, each time the original transmission data is estimated by the first decision unit 18 or the second decision unit 20, the corresponding first R/S decoder 19 or the corresponding second R/S decoder 21 alternately checks an error. When both the R/S decoders decide that "there is no error", the repeated process performed by the turbo encoder is ended. Error correction of the estimated original transmission data is performed by using the reed solomon code, and the transmission data having a higher estimation accuracy is output.

The thirdmethod solves aproblemthat error correction is performed when it is decided by the first and second methods that "there is no error" and when the repeated process is not performed. For example, in the third problem, the repeated process is performed a predetermined number of time to reduce a bit error rate to some extent, error correction of the estimated original transmission data is performed by using the reed solomon code is performed, and the transmission data having a higher estimation accuracy is output.

In this manner, when the decoder shown in Fig. 1(b) is used, and when a consternation increases with multi-valuing of a modulation scheme, a turbo decoder for performing a soft decision process for the lower two bits of a reception signal the characteristics may be deteriorated and error correction by a reed solomon code and a decision unit for performing hard decision are arranged. In this manner, a reduction of a soft decision process having a large amount of calculation and preferable transmission characteristics can be realized.

When transmission data is estimated by using the first R/S decoder 19 and the second R/S decoder 21, an iteration count can be reduced, and a soft decision process having a large amount of calculation and a process time therefore can be further reduced. In a transmission path in which a random error and a burst error exist, it is generally known that excellent transmission characteristics can be obtained by using the R-S code (reed solomon) for performing error correction in units of symbols, another conventional error correction code, and the like.

BER (Bit Error Rate) characteristics obtained when transmission data is decoded by using the turbo encoder according to the present invention are compared with BER characteristics obtained when transmission data is decoded by a conventional turbo encoder. Fig. 7 is a graph showing both the BER characteristics. For example, when the performance of turbo encoding is decided by the BER, a "minimum humming weight: $W_{min}$" obtained after the turbo encoding affects the BER having a high SNR. More specifically, when the minimum humming weight is small, it is generally known that a BER in an error flower region (region in which the BER moderately decreases) increases when the minimum humming weight is small. In this manner, in a high-$E_b/N_o$ region, i.e., an error flower region, the minimum humming weight: $W_{min}$ maximally affects the BER characteristics. In this case, as the indexes of performance comparison of the encoders, minimum humming weights of turbo code words are employed.

Fig. 8 is a table showing a minimum humming weight of the turbo encoder according to the present invention and a minimum humming weight in a conventional turbo encoder. The minimum humming weights are the minimumvalues of humming weights of encoded sequences calculated after input information bit sequences having humming weights of 2' and '3' are turbo-encoded over the entire pattern.

From the comparison and examination results in Figs . 7 and 8, it is understood that the performance of the turbo encoder having a large minimum humming weight and low BER characteristics in an error flower are apparently better than those of the conventional turbo encoder.

In this manner, when a method of inputting one sequence of transmission data to the final adder is applied to a reclusive organization, convolutional encoder (encoder) used in the turbo encoder 1, for example such a Fig. 5 (b) and Fig. 6, the influence of the transmission data can be strongly reflected on redundant data. More specifically, demodulation characteristics on the reception side can be considerably improved in comparison with the conventional turbo encoder.

In the above description, it is assumed that both the conventional turbo encoder and the turbo encoder shown in Fig. 1 use the same interleavers, and demodulation characteristics on the reception side are improved by changing the reclusive organization convolutional encoder. In the following description, by using the interleaver according to this embodiment, demodulation characteristics on the reception side are considerably improved, optimum transmission characteristics which are close to the Shannon limit, i.e., optimum BER characteristics are obtained.

For example, Figs. 9, 10, 11, 12, and 13 are tables showing the processes of the interleavers 32 and 33 used in the turbo encoder shown in Fig. 5 (a) . More specifically, Fig. 9 is a table showing an arrangement of a u1 input buffer in the interleaver 32 in Fig. 5 (a), Fig. 10 is a table showing an arrangement of a u2 input buffer in the interleaver 33, Fig. 11 is a table showing a rearrangement pattern in units of rows, Fig. 12 is a table showing a data arrangement obtained when input data sequences: u1 are mapped on a rearrangement pattern, and Fig. 13 is a diagram showing a data arrangement obtained when input data sequences: u2 are mapped on a rearrangement pattern.

A process of replacing information bit sequences at random will be described below by using the interleavers 32 and 33 for performing rearrangement of bits as shown in Figs. 9 to 13. The configuration except for the interleavers is the same as the configuration described above. For this reason, the same reference numerals as in this configuration denote the same parts in the above configuration, and a description thereof will be omitted.

The interleaver according to this embodiment performs the following four processes.

1. Information bit sequences are stored in an input buffer (289 bits) of 17 (M: abscissa) $\times$ 17 (N: ordinate) (see Figs. 9 and 10).

2. A specific 16-bit random sequence generated by a prime number is sequentially shifted column by column in units of rows to generate random sequences of 16 types. Zeros are mapped at the 17th bits of all the random sequences, the mapping pattern of the 17th row is made equal to that of the first row, and a mapping pattern of 17 (M) x 17 (N) is generated (see Fig. 11).

3. Information bit sequences having interleave lengths are mapped on the mapping pattern of 17 (M) $\times$ 17 (N) generated as described above.(see Figs. 12 and 13)

4. The mapped information bit sequences are read in units of columns and output to respective reclusive organization convolutional encoders, respectively.

The operations of the respective processes will be described below in detail. The reason why the number of bits of the abscissa is given by M=17, i . e . , the reason why the mapping pattern has 17 bits will be described below. For example, in a reclusive organization convolutional encoder, depending on the number of delay units (generally called memories), self-terminated patterns are generated at specific intervals. More specifically, when two information bit sequences are used, self-terminated patterns (input patterns the outputs of which infinitely become 0) are generated at intervals of $2^m$-1 at the most. Reference symbol m represents the number of memories.

In a case in which the reclusive organization convolutional encoder shown in Fig. 5 (b) is used, for example, when information bit sequences: u1 are {1 (first bit), 0, 0, 0, 0, 0, 0, 0, 0, 0, 0, 0, 0, 0, 0, 1 (16th bit),..., (the following bits are assumed as 0)}, and when all information bitsequence:u2are0,self-terminated patterns are generated. As the 17th bit and the following bits, 0 is infinitely output, and demodulation characteristics on the reception side are deteriorated.

In this embodiment, bits are rearranged such that self-terminated patterns can be necessarily avoided by any one of the first reclusive organization convolutional encoder 31 and the second reclusive organization convolutional encoder 34.

In order to avoid the self-terminated patterns by one of the encoders, the abscissa of an input buffer must be given by M$\geq$ $2^m$+1, and the rows (M) and the columns (N) must have random patterns. In addition, since M must be a prime number to generate a random pattern using an equation (1), the abscissa M of the input buffer, i.e., the number of bits of the mapping pattern is a value which satisfies "M $\geq$ $2^m$+1 and a prime number". In a general interleaver, in order to read the rearranged information bit sequences in units of columns by using a random pattern, self-terminated patterns must also be avoided on the ordinate. For this reason, the ordinate is given by "N $\geq 2^m$+1 (which may not be 0". Therefore, when the reclusive organization convolutional encoder having four delay units as shown in Fig. 5 (b) is used, M is a prime number is equal to or larger than 17, and N is given by N $\geq$ 17 (in this embodiment, M=17, N=17).

In the interleavers 32 and 33, information bit sequences are stored in the 17 (M) x 17 (N) input buffer (289) . At this time, since two information bit sequences are input to the turbo encoder according to this embodiment, the row of at least one information bit sequence is replaced as shown in Figs. 9 and 10 such that an inter-signal-point distance of the two information bit sequences is not 0. As a concrete replacing method, for example, all inter-signal-point distances obtained when the distance between the information bit sequence: :u1 and the information bit sequence: u2 is one row to 16 rows are calculated. Of these distances, the distances between the sequences u1 and u2 is determined to obtain optimum transmission characteristics, and the row of at least one of the sequences u1 and u2 is replaced.

In the interleavers 32 and 33, a specific 16-bit random sequence generated by using a prime number is generated. More specifically, for example, an interleave length: $L_{turbo}$=289 bits, N=17, M=P=17, and a source route: $g_0$=3 are satisfied, and a random pattern (random sequence): C is formed by using the above expression (1) . As a result, the random pattern C is given by {1, 3, 9, 10, 13, 5, 15, 11, 16, 14, 8, 7, 4, 12, 2, 6,}.

As shown in Fig. 11, a random pattern is shifted (to left) bit by bit in units of rows to generate random sequences of 16 types. More specifically, a latin square pattern (16 x 16) is formed, so that all the rows and the columns constitute random sequences. Zeros are mapped at the 17th bits of the random sequences of 16 types to generate a 17 (M) x 16 mapping pattern. In addition, the mapping pattern of the 17th row is made equal to the mapping pattern of the first row to generate a mapping pattern of 17 (M) $\times$ 17 (N) . In this manner, the method is compared with a conventional technique in which an expression is complicated to generate a pseudo random pattern, so that the interleaver can be realized with a simple configuration.

In the interleavers 32 and 33, an information bit sequence of an interleave length (289 bits in this embodiment) is mapped on the mapping pattern of 17 (M) x 17 (N) generated as described above. More specifically, as shown in Figs. 12 and 13, by using the mapping pattern of 17 (M) x 17 (N), information bit sequences in the input buffer are replaced in units of rows.

Finally, in the interleavers 32 and 33, the information bit sequences mapped as shown in Figs. 12 and 13 are read in units of columns and output to the reclusive organization convolutional encoders, respectively.

In this manner, in this embodiment, the interleavers which store information bit sequences in an input buffer of "M $\geq$ $2^m$+1 and prime number" x "N $\geq$ $2^m$+1", shift a random sequence of a specific (M-1) bit generated by using a prime number bit by bit in units of rows to generate random sequences of (M-1) types, and map the information bit sequences on an M x N mapping pattern generated from the random sequences of (M-1) types is arranged. In addition, a self-terminated pattern can be avoided by any one of the first reclusive organization convolutional encoder 31 and the second reclusive organization convolutional encoder 34. For this reason, error correction capability can be considerably improved. In this manner, since demodulation characteristics on the reception side can be more considerably improved, optimum transmission characteristics which are close to the Shannon limit, i.e., optimum BER characteristics can be obtained.

In this embodiment, the information bit sequences mapped on the mapping pattern of 17 (M) x 17 (N) are read in units of columns. However, the present invention is not limited to the embodiment, since N is "N $\geq$ $2^m$+1", for example, N maybe increased by natural numbers, i.e., N=18, 19, 20, .... In this manner, the flexibility of an interleave length can be improved. In addition, although the flexibility of the interleave length cannot be improved, for example, M may be changed in a range in which "M$\geq$ $2^m$+1 and prime number" (for example, 19, 23, 29,...).

In this embodiment, as described above, the terminal process is performed such that all the 17th bits of the mapping pattern are set to be 0 (the start bits of information bit sequences corresponding to respective rows. However, the present invention is not limited to the embodiment, in contrast to this, the first bits of the mapping pattern are set to be 17 (the final bits of information bit sequences corresponding to respective rows), and a latin square pattern of 16 x 16 is formed by the second and following bits. In this manner, since the 289th bit of an information bit sequence read as a final bit before interleave can be read in the start row after the interleave is performed, the number of parities after convolution is performed.

As described above, according to the present invention, the interleavers which store information bit sequences in an input buffer of "M $\geq$ $2^m$+1 and prime number" x "N $\geq$ $2^m$+1", shift a random sequence of a specific (M-1) bit generated by using a prime number bit by bit in units of rows to generate random sequences of (M-1) types, and map the information bit sequences on an M x N mapping pattern generated from the random sequences of (M-1) types is arranged. Inaddition, a self-terminated pattern can be avoided by any one of the first reclusive organization convolutional encoder 31 and the second reclusive organization convolutional encoder 34. For this reason, error correction capability can be considerably improved. In this manner, since demodulation characteristics on the reception side can be more considerably improved, optimum transmission characteristics which are close to the Shannon limit, i , e . , optimum BER characteristics can be obtained advantageously.

According to the next invention, when all inter-signal distances when the distance between two information bit sequences is one row to (N-1) row are calculated, a communication device which can select optimum transmission characteristics from the inter-signal distances advantageously.

According to the next invention, a communication device in which an interleaver having a configuration which is simpler than that of a conventional communication device in which an expression is complicated to generate a pseudo random pattern can be obtained advantageously.

According to the next invention, a communication device which can improve the flexibility of an interleave length can be obtained advantageously.

According to the next invention, the (M x N)th bit of an information bit sequence read as a final bit can be read on the start row after interleave is performed. For this reason, a communication device which can reliably increase the number of parities after convolution is performed advantageously.

According to the next invention, the interleavers which store information bit sequences in an input buffer of "M $\geq 2^m+1$ and prime number" x "N $\geq 2^m+1$", shift a random sequence of a specific (M-1) bit generated by using a prime number bit by bit in units of rows to generate random sequences of (M-1) types, and map the information bit sequences on an M x N mapping pattern generated from the random sequences of (M-1) types is arranged. In addition, a self-terminated pattern can be avoided by any one of the first reclusive organization convolutional encoder 31 and the second reclusive organization convolutional encoder 34. For this reason, error correction capability can be considerably improved. In this manner, since demodulation characteristics on the reception side can be more considerably improved, optimum transmission characteristics which are close to the Shannon limit, i.e., optimum BER characteristics can be obtained advantageously.

According to the next invention, when all inter-signal distances when the distance between two information bit sequences is one row to (N-1) row are calculated, a communication device which can select optimum transmission characteristics from the inter-signal distances advantageously.

According to the next invention, an interleaver having a configuration which is simpler than that of a conventional interleaver in which an expression is complicated to generate a pseudo random pattern can be realized advantageously.

According to the next invention, the flexibility of an interleave length can be improved advantageously.

According to the next invention, the (M x N)th bit of an information bit sequence read as a final bit can be read on the start row after interleave is performed. For this reason, the number of parities after convolution is performed can be reliably increased advantageously.

INDUSTRIAL APPLICABILITY

As has been described above, a communication device and a communication method according to the present invention is suitable for data communication using a conventional communication line by the DMT (Discrete Multi Tone) modulation/demodulation scheme, the OFDM (Orthogonal Frequency Division Multiplex) modulation/demodulation scheme, or the like.

**Claims**

1. A communication device comprising a turbo encoder having
   a first reclusive organization convolutional encoder for convolutionally encoding two information bit sequences to output first redundant data; and
   a second reclusive organization convolutional encoder for convolutionally encoding the information bit sequences subjected to the interleave process to output second redundant data; and
   an interleaver which
   stores the information bit sequences in an input buffer of "M (abscissa: prime number)=$2^m+1$" x "N (ordinate: natural number)=$2^m$" (m is an integer),
   generates random sequences of (M-1) types by shifting a random sequence of a specific (M-1) bit generated by using the prime number bit by bit in units of rows and maps minimum values at Mth bits of respective rows in all the random sequences and makes a mapping pattern of an Nth row equal to that of the first row to generate an M x N mapping pattern,
   maps information bit sequences of an interleave length on the M x N mapping pattern, and
   reads the mapped information bit sequences in units of columns to output the information bit sequences to the second reclusive organization convolutional encoder .

2. The communication device according to claim 1, wherein the interleaver, when the two information bit sequences are stored in the input buffer, replaces at least one row such that an inter-signal-point distance of the information bit sequences is not 0.

3. The communication device according to claim 1, wherein the interleaver forms a latin square pattern in a buffer of (M-1) x (N-1) as random sequences of the (M-1) types.

4. The communication device according to claim 1, wherein the interleaver determines N to satisfy "N (ordinate: natural number) $\geq 2^m+1$".

5. The communication device according to claim 1, wherein the interleaver maps maximum values at the starts of all the rows in random sequences of the prime number (M-1), and makes a mapping pattern of an Nth row equal to a mapping pattern of the first row to generate an M x N mapping pattern.

6. The communication method which rearranges two information bit sequences in a turbo encoder, comprising:

the bit sequence storing step of storing the information bit sequences in an input buffer of "M (abscissa: prime number)=$2^m$+1" x "N (ordinate: natural number)=$2^m$";
the mapping pattern generation step of generating random sequences of (M-1) types by shifting a random sequence of a specific (M-1) bit generated by using the prime number bit by bit in units of rows, mapping minimum values at Mth bits of respective rows in all the random sequences, and making a mapping pattern of an Nth row equal to that of the first row to generate an M x N mapping pattern;
the mapping step of mapping information bit sequences of an interleave length on the M x N mapping pattern; and
the bit sequence read step of reading the mapped information bit sequences in units of columns.

7. The communication method according to claim 6, wherein, in the bit sequence storing step, when the two information bit sequences are stored in the input buffer, at least one row is replaced such that an inter-signal-point distance of these information bit sequences is not 0.

8. The communication method according to claim 6, wherein, in the mapping pattern generation step, a latin square pattern is formed in a buffer of (M-1) x (N-1) as random sequences of the (M-1) types.

9. The communication method according to claim 6, wherein N is determined to satisfy "N (ordinate: natural number) $\geq 2^m$+ 1" .

10. The communication method according to claim 6, wherein, in the mapping pattern generation step, maximum values are mapped at the starts of all the rows in random sequences of the prime number (M-1) , and a mapping pattern of an Nth row is made equal to a mapping pattern of the first row to generate an M x N mapping pattern.

EP 1 841 076 A1

# FIG.1

(a)

(b)

14

# FIG.2

EP 1 841 076 A1

# FIG.3

16

# FIG.4

(a)

(b)

(c)

# FIG.5

(a)

(b)

# FIG.6

# FIG.7

# FIG.8

| INTERLEAVER SIZE (bit) | CONVENTIONAL ENCODER | PROPOSED ENCODER |
|---|---|---|
| 128 | 10 | 11 |
| 256 | 10 | 11 |
| 512 | 10 | 12 |

# FIG.9

| N\M | 1 | 2 | 3 | 4 | 5 | 6 | 7 | 8 | 9 | 10 | 11 | 12 | 13 | 14 | 15 | 16 | 17 |
|---|---|---|---|---|---|---|---|---|---|---|---|---|---|---|---|---|---|
| 1 | 0 | 1 | 2 | 3 | 4 | 5 | 6 | 7 | 8 | 9 | 10 | 11 | 12 | 13 | 14 | 15 | 16 |
| 2 | 17 | 18 | 19 | 20 | 21 | 22 | 23 | 24 | 25 | 26 | 27 | 28 | 29 | 30 | 31 | 32 | 33 |
| 3 | 34 | 35 | 36 | 37 | 38 | 39 | 40 | 41 | 42 | 43 | 44 | 45 | 46 | 47 | 48 | 49 | 50 |
| 4 | 51 | 52 | 53 | 54 | 55 | 56 | 57 | 58 | 59 | 60 | 61 | 62 | 63 | 64 | 65 | 56 | 67 |
| 5 | 68 | 69 | 70 | 71 | 72 | 73 | 74 | 75 | 76 | 77 | 78 | 79 | 80 | 81 | 82 | 83 | 84 |
| 6 | 85 | 86 | 87 | 88 | 89 | 90 | 91 | 92 | 93 | 94 | 95 | 96 | 97 | 98 | 99 | 100 | 101 |
| 7 | 102 | 103 | 104 | 105 | 106 | 107 | 108 | 109 | 110 | 111 | 112 | 113 | 114 | 115 | 116 | 117 | 118 |
| 8 | 119 | 120 | 121 | 122 | 123 | 124 | 125 | 126 | 127 | 128 | 129 | 130 | 131 | 132 | 133 | 134 | 135 |
| 9 | 136 | 137 | 138 | 139 | 140 | 141 | 142 | 143 | 144 | 145 | 146 | 147 | 148 | 149 | 150 | 151 | 152 |
| 10 | 153 | 154 | 155 | 156 | 157 | 158 | 159 | 160 | 161 | 162 | 163 | 154 | 165 | 166 | 167 | 168 | 169 |
| 11 | 170 | 171 | 172 | 173 | 174 | 175 | 176 | 177 | 178 | 179 | 180 | 181 | 182 | 183 | 184 | 185 | 188 |
| 12 | 187 | 188 | 189 | 190 | 191 | 192 | 193 | 194 | 195 | 196 | 197 | 198 | 199 | 200 | 201 | 202 | 203 |
| 13 | 204 | 205 | 206 | 207 | 208 | 209 | 210 | 211 | 212 | 213 | 214 | 215 | 216 | 217 | 218 | 219 | 220 |
| 14 | 221 | 222 | 223 | 224 | 225 | 226 | 227 | 228 | 229 | 230 | 231 | 232 | 233 | 234 | 235 | 236 | 237 |
| 15 | 238 | 239 | 240 | 241 | 242 | 243 | 244 | 245 | 246 | 247 | 248 | 249 | 250 | 251 | 252 | 253 | 254 |
| 16 | 255 | 256 | 257 | 258 | 259 | 260 | 261 | 262 | 263 | 264 | 265 | 266 | 267 | 268 | 269 | 270 | 271 |
| 17 | 272 | 273 | 274 | 275 | 276 | 277 | 278 | 279 | 280 | 281 | 282 | 283 | 284 | 285 | 286 | 287 | 288 |

EP 1 841 076 A1

# FIG.10

| N\M | 1 | 2 | 3 | 4 | 5 | 6 | 7 | 8 | 9 | 10 | 11 | 12 | 13 | 14 | 15 | 16 | 17 |
|---|---|---|---|---|---|---|---|---|---|---|---|---|---|---|---|---|---|
| 1 | 17 | 18 | 19 | 20 | 21 | 22 | 23 | 24 | 25 | 26 | 27 | 28 | 29 | 30 | 31 | 32 | 33 |
| 2 | 34 | 35 | 36 | 37 | 38 | 39 | 40 | 41 | 42 | 43 | 44 | 45 | 46 | 47 | 48 | 49 | 50 |
| 3 | 51 | 52 | 53 | 54 | 55 | 56 | 57 | 58 | 59 | 60 | 61 | 62 | 63 | 64 | 65 | 66 | 67 |
| 4 | 68 | 69 | 70 | 71 | 72 | 73 | 74 | 75 | 76 | 77 | 78 | 79 | 80 | 81 | 82 | 83 | 84 |
| 5 | 85 | 86 | 87 | 88 | 89 | 90 | 91 | 92 | 93 | 94 | 95 | 96 | 97 | 98 | 99 | 100 | 101 |
| 6 | 102 | 103 | 104 | 105 | 106 | 107 | 108 | 109 | 110 | 111 | 112 | 113 | 114 | 115 | 116 | 117 | 118 |
| 7 | 119 | 120 | 121 | 122 | 123 | 124 | 125 | 126 | 127 | 128 | 129 | 130 | 131 | 132 | 133 | 134 | 135 |
| 8 | 136 | 137 | 138 | 139 | 140 | 141 | 142 | 143 | 144 | 145 | 146 | 147 | 148 | 149 | 150 | 151 | 152 |
| 9 | 153 | 154 | 155 | 156 | 157 | 158 | 159 | 160 | 161 | 162 | 163 | 164 | 165 | 166 | 167 | 168 | 169 |
| 10 | 170 | 171 | 172 | 173 | 174 | 175 | 176 | 177 | 178 | 179 | 180 | 181 | 182 | 183 | 184 | 185 | 186 |
| 11 | 187 | 188 | 189 | 190 | 191 | 192 | 193 | 194 | 195 | 196 | 197 | 198 | 199 | 200 | 201 | 202 | 203 |
| 12 | 204 | 205 | 206 | 207 | 208 | 209 | 210 | 211 | 212 | 213 | 214 | 215 | 216 | 217 | 218 | 219 | 220 |
| 13 | 221 | 222 | 223 | 224 | 225 | 226 | 227 | 228 | 229 | 230 | 231 | 232 | 233 | 234 | 235 | 236 | 237 |
| 14 | 238 | 238 | 240 | 241 | 242 | 243 | 244 | 245 | 246 | 247 | 248 | 249 | 250 | 251 | 252 | 253 | 254 |
| 15 | 255 | 256 | 257 | 258 | 259 | 260 | 261 | 262 | 263 | 264 | 265 | 266 | 267 | 268 | 269 | 270 | 271 |
| 16 | 272 | 273 | 274 | 275 | 276 | 277 | 278 | 279 | 280 | 281 | 282 | 283 | 284 | 285 | 286 | 287 | 288 |
| 17 | 0 | 1 | 2 | 3 | 4 | 5 | 6 | 7 | 8 | 9 | 10 | 11 | 12 | 13 | 14 | 15 | 16 |

EP 1 841 076 A1

# FIG.11

| N＼M | 1 | 2 | 3 | 4 | 5 | 6 | 7 | 8 | 9 | 10 | 11 | 12 | 13 | 14 | 15 | 16 | 17 |
|---|---|---|---|---|---|---|---|---|---|---|---|---|---|---|---|---|---|
| 1 | 1 | 3 | 9 | 10 | 13 | 5 | 15 | 11 | 16 | 14 | 8 | 7 | 4 | 12 | 2 | 6 | 0 |
| 2 | 3 | 9 | 10 | 13 | 5 | 15 | 11 | 16 | 14 | 8 | 7 | 4 | 12 | 2 | 6 | 1 | 0 |
| 3 | 9 | 10 | 13 | 5 | 15 | 11 | 16 | 14 | 8 | 7 | 4 | 12 | 2 | 6 | 1 | 3 | 0 |
| 4 | 10 | 13 | 5 | 15 | 11 | 16 | 14 | 8 | 7 | 4 | 12 | 2 | 6 | 1 | 3 | 9 | 0 |
| 5 | 13 | 5 | 15 | 11 | 16 | 14 | 8 | 7 | 4 | 12 | 2 | 6 | 1 | 3 | 9 | 10 | 0 |
| 6 | 5 | 15 | 11 | 16 | 14 | 8 | 7 | 4 | 12 | 2 | 6 | 1 | 3 | 9 | 10 | 13 | 0 |
| 7 | 15 | 11 | 16 | 14 | 8 | 7 | 4 | 12 | 2 | 6 | 1 | 3 | 9 | 10 | 13 | 5 | 0 |
| 8 | 11 | 16 | 14 | 8 | 7 | 4 | 12 | 2 | 6 | 1 | 3 | 9 | 10 | 13 | 5 | 15 | 0 |
| 9 | 16 | 14 | 8 | 7 | 4 | 12 | 2 | 6 | 1 | 3 | 9 | 10 | 13 | 5 | 15 | 11 | 0 |
| 10 | 14 | 8 | 7 | 4 | 12 | 2 | 6 | 1 | 3 | 9 | 10 | 13 | 5 | 15 | 11 | 16 | 0 |
| 11 | 8 | 7 | 4 | 12 | 2 | 6 | 1 | 3 | 9 | 10 | 13 | 5 | 15 | 11 | 16 | 14 | 0 |
| 12 | 7 | 4 | 12 | 2 | 6 | 1 | 3 | 9 | 10 | 13 | 5 | 15 | 11 | 16 | 14 | 8 | 0 |
| 13 | 4 | 12 | 2 | 6 | 1 | 3 | 9 | 10 | 13 | 5 | 15 | 11 | 16 | 14 | 8 | 7 | 0 |
| 14 | 12 | 2 | 6 | 1 | 3 | 9 | 10 | 13 | 5 | 15 | 11 | 16 | 14 | 8 | 7 | 4 | 0 |
| 15 | 2 | 6 | 1 | 3 | 9 | 10 | 13 | 5 | 15 | 11 | 16 | 14 | 8 | 7 | 4 | 12 | 0 |
| 16 | 6 | 1 | 3 | 9 | 10 | 13 | 5 | 15 | 11 | 16 | 14 | 8 | 7 | 4 | 12 | 2 | 0 |
| 17 | 1 | 3 | 9 | 10 | 13 | 5 | 15 | 11 | 16 | 14 | 8 | 7 | 4 | 12 | 2 | 6 | 0 |

EP 1 841 076 A1

# FIG.12

| N\M | 1 | 2 | 3 | 4 | 5 | 6 | 7 | 8 | 9 | 10 | 11 | 12 | 13 | 14 | 15 | 16 | 17 |
|---|---|---|---|---|---|---|---|---|---|---|---|---|---|---|---|---|---|
| 1 | 1 | 3 | 9 | 10 | 13 | 5 | 15 | 11 | 16 | 14 | 8 | 7 | 4 | 12 | 2 | 6 | 0 |
| 2 | 20 | 26 | 27 | 30 | 22 | 32 | 28 | 33 | 31 | 25 | 24 | 21 | 29 | 19 | 23 | 18 | 17 |
| 3 | 43 | 44 | 47 | 39 | 49 | 45 | 50 | 48 | 42 | 41 | 38 | 46 | 36 | 40 | 35 | 37 | 34 |
| 4 | 61 | 64 | 56 | 66 | 62 | 67 | 65 | 59 | 58 | 55 | 63 | 53 | 57 | 52 | 54 | 60 | 51 |
| 5 | 81 | 73 | 83 | 79 | 84 | 82 | 76 | 75 | 72 | 80 | 70 | 74 | 69 | 71 | 77 | 78 | 68 |
| 6 | 90 | 100 | 96 | 101 | 99 | 93 | 92 | 89 | 97 | 87 | 91 | 86 | 88 | 94 | 95 | 98 | 85 |
| 7 | 117 | 113 | 118 | 116 | 110 | 109 | 105 | 114 | 104 | 108 | 103 | 105 | 111 | 112 | 115 | 107 | 102 |
| 8 | 130 | 135 | 133 | 127 | 126 | 123 | 131 | 121 | 125 | 120 | 122 | 128 | 129 | 132 | 124 | 134 | 119 |
| 9 | 152 | 150 | 144 | 143 | 140 | 148 | 138 | 142 | 137 | 139 | 145 | 146 | 149 | 141 | 151 | 147 | 136 |
| 10 | 167 | 161 | 160 | 157 | 165 | 155 | 159 | 154 | 156 | 162 | 163 | 166 | 158 | 168 | 164 | 169 | 153 |
| 11 | 178 | 177 | 174 | 182 | 172 | 176 | 171 | 173 | 179 | 180 | 183 | 175 | 185 | 181 | 186 | 184 | 170 |
| 12 | 194 | 191 | 199 | 189 | 193 | 188 | 190 | 196 | 197 | 200 | 192 | 202 | 198 | 203 | 201 | 195 | 187 |
| 13 | 208 | 216 | 206 | 210 | 205 | 207 | 213 | 214 | 217 | 209 | 219 | 215 | 220 | 218 | 212 | 211 | 204 |
| 14 | 233 | 223 | 227 | 222 | 224 | 230 | 231 | 234 | 226 | 236 | 232 | 237 | 235 | 229 | 228 | 225 | 221 |
| 15 | 240 | 244 | 239 | 241 | 247 | 248 | 251 | 243 | 253 | 249 | 254 | 252 | 246 | 245 | 242 | 250 | 238 |
| 16 | 261 | 256 | 258 | 264 | 265 | 268 | 260 | 270 | 266 | 271 | 269 | 263 | 262 | 259 | 267 | 257 | 255 |
| 17 | 273 | 275 | 281 | 282 | 285 | 277 | 287 | 283 | 288 | 286 | 280 | 279 | 279 | 284 | 274 | 278 | 272 |

EP 1 841 076 A1

# FIG.13

| N＼M | 1 | 2 | 3 | 4 | 5 | 6 | 7 | 8 | 9 | 10 | 11 | 12 | 13 | 14 | 15 | 16 | 17 |
|---|---|---|---|---|---|---|---|---|---|---|---|---|---|---|---|---|---|
| 1 | 18 | 20 | 26 | 27 | 30 | 22 | 32 | 28 | 33 | 31 | 25 | 24 | 21 | 29 | 19 | 23 | 17 |
| 2 | 37 | 43 | 44 | 47 | 39 | 49 | 45 | 50 | 48 | 42 | 41 | 38 | 46 | 36 | 40 | 35 | 34 |
| 3 | 60 | 61 | 64 | 56 | 66 | 62 | 67 | 65 | 59 | 58 | 55 | 63 | 53 | 57 | 52 | 54 | 51 |
| 4 | 78 | 81 | 73 | 83 | 79 | 84 | 82 | 76 | 75 | 72 | 80 | 70 | 74 | 69 | 71 | 77 | 68 |
| 5 | 98 | 90 | 100 | 96 | 101 | 99 | 93 | 92 | 89 | 97 | 87 | 91 | 86 | 88 | 94 | 95 | 85 |
| 6 | 107 | 117 | 113 | 118 | 116 | 110 | 109 | 106 | 114 | 104 | 108 | 103 | 105 | 111 | 112 | 115 | 102 |
| 7 | 134 | 130 | 135 | 133 | 127 | 126 | 123 | 131 | 121 | 125 | 120 | 122 | 128 | 129 | 132 | 124 | 119 |
| 8 | 147 | 152 | 150 | 144 | 143 | 140 | 148 | 138 | 142 | 137 | 139 | 145 | 146 | 149 | 141 | 151 | 136 |
| 9 | 169 | 167 | 161 | 160 | 157 | 165 | 156 | 159 | 154 | 156 | 162 | 163 | 166 | 158 | 168 | 164 | 153 |
| 10 | 184 | 178 | 177 | 174 | 182 | 172 | 176 | 171 | 173 | 179 | 180 | 183 | 175 | 185 | 181 | 186 | 170 |
| 11 | 195 | 194 | 191 | 199 | 189 | 193 | 188 | 190 | 196 | 197 | 200 | 192 | 202 | 198 | 203 | 201 | 187 |
| 12 | 211 | 208 | 216 | 206 | 210 | 205 | 207 | 213 | 214 | 217 | 209 | 219 | 215 | 220 | 218 | 212 | 204 |
| 13 | 225 | 233 | 223 | 227 | 222 | 224 | 230 | 231 | 234 | 226 | 236 | 232 | 237 | 235 | 229 | 228 | 221 |
| 14 | 250 | 240 | 244 | 239 | 241 | 247 | 248 | 251 | 243 | 253 | 249 | 254 | 252 | 246 | 245 | 242 | 238 |
| 15 | 257 | 261 | 255 | 258 | 264 | 265 | 268 | 260 | 270 | 266 | 271 | 269 | 263 | 262 | 259 | 267 | 255 |
| 16 | 278 | 273 | 275 | 281 | 282 | 285 | 277 | 287 | 283 | 288 | 286 | 280 | 279 | 276 | 284 | 274 | 272 |
| 17 | 1 | 3 | 9 | 10 | 13 | 5 | 15 | 11 | 16 | 14 | 8 | 7 | 4 | 12 | 2 | 6 | 0 |

EP 1 841 076 A1

# FIG.14

(a)

DATA ○——————•————•————————————————————→ x₁

FIRST RECLUSIVE
ORGANIZATION
CONVOLUTIONAL ENCODER
⌐101

——————→ x₂

INTERLEAVER
⌐102

SECOND RECLUSIVE
ORGANIZATION
CONVOLUTIONAL
ENCODER
⌐103

——————→ x₃

(b)

# FIG.15

EP 1 841 076 A1

## FIG.16

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 1 | 21 | 17 | 39 | 24 | 27 | 37 | 35 | 46 | 12 | 40 | 45 | 44 | 23 | 6 | 20 | 49 | 22 | 38 | 3 |
| 3 | 1 | 45 | 11 | 18 | 15 | 39 | 6 | 5 | 13 | 2 | 37 | 22 | 36 | 30 | 25 | 12 | 10 | 26 | 4 | 21 |
| 4 | 1 | 33 | 29 | 3 | 46 | 34 | 9 | 32 | 49 | 27 | 43 | 41 | 28 | 23 | 17 | 31 | 16 | 51 | 40 | 48 |
| 5 | 1 | 12 | 38 | 32 | 13 | 50 | 17 | 45 | 10 | 14 | 9 | 2 | 24 | 23 | 11 | 26 | 47 | 34 | 37 | 20 |
| 6 | 1 | 3 | 9 | 27 | 28 | 31 | 40 | 14 | 42 | 20 | 7 | 21 | 10 | 30 | 37 | 5 | 15 | 45 | 29 | 34 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 1 | 34 | 43 | 31 | 47 | 8 | 7 | 26 | 36 | 5 | 11 | 3 | 49 | 23 | 40 | 35 | 24 | 21 | 25 | 2 |
| 9 | 1 | 22 | 7 | 48 | 49 | 18 | 25 | 20 | 16 | 34 | 6 | 26 | 42 | 23 | 29 | 2 | 44 | 14 | 43 | 45 |
| 10 | 1 | 2 | 4 | 8 | 16 | 32 | 11 | 22 | 44 | 35 | 17 | 34 | 15 | 30 | 7 | 14 | 28 | 3 | 6 | 12 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 40 |
| 2 | 10 | 51 | 11 | 19 | 28 | 5 | 52 | 32 | 36 | 14 | 29 | 26 | 16 | 18 | 7 | 41 | 13 | 8 | 9 | 23 |
| 3 | 44 | 19 | 7 | 50 | 24 | 20 | 32 | 8 | 42 | 35 | 38 | 14 | 47 | 48 | 40 | 51 | 16 | 31 | 17 | 30 |
| 4 | 47 | 14 | 38 | 35 | 42 | 8 | 52 | 20 | 24 | 50 | 7 | 19 | 44 | 21 | 4 | 26 | 10 | 12 | 25 | 23 |
| 5 | 28 | 18 | 4 | 48 | 46 | 22 | 52 | 41 | 15 | 21 | 40 | 3 | 36 | 8 | 43 | 39 | 44 | 51 | 29 | 30 |
| 6 | 49 | 41 | 17 | 51 | 47 | 35 | 52 | 50 | 44 | 26 | 25 | 22 | 13 | 39 | 11 | 33 | 46 | 32 | 43 | 30 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 15 | 33 | 9 | 41 | 16 | 14 | 52 | 19 | 10 | 22 | 6 | 45 | 46 | 27 | 17 | 48 | 42 | 50 | 4 | 23 |
| 9 | 36 | 50 | 40 | 32 | 15 | 12 | 52 | 31 | 46 | 5 | 4 | 35 | 28 | 33 | 37 | 19 | 47 | 27 | 11 | 30 |
| 10 | 24 | 48 | 43 | 33 | 13 | 26 | 52 | 51 | 49 | 45 | 37 | 21 | 42 | 31 | 9 | 18 | 36 | 19 | 38 | 23 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 47 | 33 | 4 | 31 | 15 | 50 | 43 | 2 | 42 | 34 | 25 | 48 | 0 |
| 3 | 28 | 41 | 43 | 27 | 49 | 32 | 9 | 34 | 46 | 3 | 29 | 33 | 0 |
| 4 | 36 | 22 | 37 | 2 | 13 | 5 | 6 | 39 | 15 | 18 | 11 | 45 | 0 |
| 5 | 42 | 27 | 6 | 19 | 16 | 33 | 25 | 35 | 49 | 5 | 7 | 31 | 0 |
| 6 | 16 | 48 | 38 | 8 | 24 | 19 | 4 | 12 | 36 | 2 | 6 | 18 | 0 |
| 7 | 1 | 30 | 52 | 23 | 1 | 30 | 52 | 23 | 1 | 30 | 52 | 23 | 0 |
| 8 | 13 | 18 | 29 | 32 | 28 | 51 | 38 | 20 | 44 | 12 | 37 | 39 | 0 |
| 9 | 24 | 51 | 9 | 39 | 10 | 8 | 17 | 3 | 13 | 21 | 38 | 41 | 0 |
| 10 | 45 | 39 | 25 | 50 | 47 | 41 | 29 | 5 | 10 | 20 | 40 | 27 | 0 |

# FIG.17

**M = 1 to 20**

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 54 | 74 | 70 | 92 | 77 | 80 | 90 | 88 | 99 | 65 | 93 | 98 | 97 | 76 | 59 | 73 | 102 | 75 | 91 | 56 |
| 3 | 107 | 151 | 117 | 124 | 121 | 145 | 112 | 111 | 119 | 108 | 143 | 128 | 142 | 136 | 131 | 118 | 116 | 132 | 110 | 127 |
| 4 | 160 | 192 | 188 | 162 | 205 | 193 | 168 | 191 | 208 | 186 | 202 | 200 | 187 | 182 | 176 | 190 | 175 | 210 | 199 | 207 |
| 5 | 213 | 224 | 250 | 244 | 225 | 262 | 229 | 257 | 222 | 226 | 221 | 214 | 236 | 235 | 223 | 238 | 259 | 246 | 249 | 232 |
| 6 | 266 | 268 | 274 | 292 | 293 | 296 | 305 | 279 | 307 | 285 | 272 | 286 | 275 | 295 | 302 | 270 | 280 | 310 | 294 | 299 |
| 7 | 319 | 348 | 370 | 341 | 319 | 348 | 370 | 341 | 319 | 348 | 370 | 341 | 319 | 348 | 370 | 341 | 319 | 388 | 370 | 341 |
| 8 | 372 | 405 | 414 | 402 | 418 | 379 | 378 | 397 | 407 | 376 | 382 | 374 | 420 | 394 | 411 | 406 | 395 | 392 | 396 | 373 |
| 9 | 425 | 446 | 431 | 472 | 473 | 442 | 449 | 444 | 440 | 458 | 430 | 450 | 466 | 447 | 453 | 426 | 468 | 430 | 467 | 469 |
| 10 | 478 | 479 | 481 | 485 | 493 | 509 | 488 | 499 | 521 | 512 | 494 | 511 | 492 | 507 | 484 | 491 | 505 | 480 | 483 | 489 |

**M = 21 to 40**

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 23 |
| 2 | 63 | 104 | 64 | 72 | 81 | 58 | 105 | 85 | 89 | 67 | 82 | 79 | 69 | 71 | 60 | 94 | 66 | 61 | 62 | 83 |
| 3 | 150 | 125 | 113 | 156 | 130 | 126 | 158 | 114 | 148 | 141 | 144 | 120 | 153 | 154 | 146 | 157 | 122 | 137 | 123 | 129 |
| 4 | 206 | 173 | 197 | 194 | 201 | 167 | 211 | 179 | 183 | 209 | 166 | 178 | 203 | 180 | 163 | 185 | 169 | 171 | 184 | 189 |
| 5 | 240 | 230 | 216 | 260 | 258 | 234 | 264 | 253 | 227 | 233 | 252 | 215 | 246 | 220 | 255 | 251 | 256 | 263 | 241 | 242 |
| 6 | 314 | 306 | 282 | 316 | 312 | 300 | 319 | 315 | 309 | 291 | 290 | 287 | 218 | 304 | 276 | 298 | 311 | 297 | 308 | 288 |
| 7 | 319 | 348 | 370 | 341 | 319 | 348 | 370 | 341 | 319 | 348 | 370 | 341 | 319 | 348 | 370 | 341 | 319 | 348 | 370 | 341 |
| 8 | 386 | 404 | 380 | 412 | 387 | 385 | 423 | 390 | 381 | 393 | 377 | 416 | 417 | 398 | 388 | 419 | 413 | 421 | 375 | 401 |
| 9 | 460 | 474 | 464 | 456 | 439 | 436 | 476 | 455 | 470 | 429 | 428 | 459 | 452 | 457 | 461 | 443 | 471 | 451 | 435 | 454 |
| 10 | 501 | 525 | 520 | 510 | 490 | 503 | 529 | 528 | 526 | 522 | 514 | 498 | 519 | 508 | 486 | 495 | 543 | 496 | 515 | 500 |

**M = 41 to 53**

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 100 | 86 | 57 | 84 | 68 | 103 | 96 | 55 | 95 | 87 | 78 | 101 | 53 |
| 3 | 134 | 147 | 149 | 133 | 155 | 138 | 115 | 140 | 152 | 109 | 135 | 139 | 106 |
| 4 | 195 | 181 | 196 | 161 | 172 | 164 | 165 | 198 | 174 | 177 | 170 | 204 | 159 |
| 5 | 254 | 239 | 218 | 231 | 228 | 245 | 237 | 247 | 261 | 217 | 219 | 243 | 212 |
| 6 | 281 | 313 | 303 | 273 | 289 | 284 | 269 | 277 | 301 | 267 | 271 | 283 | 265 |
| 7 | 319 | 348 | 370 | 341 | 319 | 348 | 370 | 341 | 319 | 348 | 370 | 341 | 318 |
| 8 | 384 | 389 | 400 | 403 | 399 | 422 | 409 | 391 | 415 | 383 | 408 | 410 | 371 |
| 9 | 448 | 475 | 433 | 463 | 434 | 432 | 441 | 427 | 437 | 445 | 462 | 465 | 424 |
| 10 | 523 | 516 | 502 | 527 | 524 | 518 | 506 | 482 | 487 | 497 | 517 | 504 | 477 |

FIG.18

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 478 | 479 | 481 | 485 | 493 | 509 | 488 | 499 | 521 | 512 | 494 | 511 | 492 | 507 | 484 | 491 | 505 | 480 | 483 | 489 |
| 2 | 425 | 446 | 431 | 472 | 473 | 442 | 449 | 444 | 440 | 458 | 430 | 450 | 466 | 447 | 453 | 426 | 468 | 438 | 467 | 469 |
| 3 | 372 | 405 | 414 | 402 | 418 | 379 | 378 | 397 | 407 | 376 | 382 | 374 | 420 | 394 | 411 | 406 | 395 | 392 | 396 | 373 |
| 4 | 319 | 348 | 370 | 341 | 319 | 348 | 370 | 341 | 319 | 348 | 370 | 341 | 319 | 348 | 370 | 341 | 319 | 348 | 370 | 341 |
| 5 | 266 | 268 | 274 | 292 | 293 | 296 | 305 | 279 | 307 | 285 | 272 | 286 | 275 | 295 | 302 | 270 | 280 | 310 | 294 | 299 |
| 6 | 213 | 224 | 250 | 244 | 225 | 262 | 229 | 257 | 222 | 226 | 221 | 214 | 236 | 235 | 223 | 238 | 259 | 246 | 249 | 232 |
| 7 | 160 | 192 | 188 | 162 | 205 | 193 | 168 | 191 | 208 | 186 | 202 | 200 | 187 | 182 | 176 | 190 | 175 | 210 | 199 | 207 |
| 8 | 107 | 151 | 117 | 124 | 121 | 145 | 112 | 111 | 119 | 108 | 143 | 128 | 142 | 136 | 131 | 118 | 116 | 132 | 110 | 127 |
| 9 | 54 | 74 | 70 | 92 | 77 | 80 | 90 | 88 | 99 | 65 | 93 | 98 | 97 | 76 | 59 | 73 | 102 | 75 | 91 | 56 |
| 10 | 1 | 19 | 43 | 22 | 47 | 45 | 7 | 27 | 36 | 48 | 11 | 50 | 49 | 30 | 40 | 18 | 24 | 32 | 25 | 51 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 501 | 525 | 520 | 510 | 490 | 503 | 529 | 528 | 526 | 522 | 514 | 498 | 519 | 508 | 486 | 495 | 513 | 496 | 515 | 500 |
| 2 | 460 | 474 | 464 | 456 | 439 | 436 | 476 | 455 | 470 | 429 | 428 | 459 | 452 | 457 | 461 | 443 | 471 | 451 | 435 | 454 |
| 3 | 386 | 404 | 380 | 412 | 387 | 385 | 423 | 390 | 381 | 393 | 377 | 416 | 417 | 398 | 388 | 419 | 413 | 421 | 375 | 401 |
| 4 | 319 | 348 | 370 | 341 | 319 | 348 | 370 | 341 | 319 | 348 | 370 | 341 | 319 | 348 | 370 | 341 | 319 | 348 | 370 | 341 |
| 5 | 314 | 306 | 282 | 316 | 312 | 300 | 317 | 315 | 309 | 291 | 290 | 287 | 278 | 304 | 276 | 298 | 311 | 297 | 308 | 288 |
| 6 | 240 | 230 | 216 | 260 | 258 | 234 | 264 | 253 | 227 | 233 | 252 | 215 | 248 | 220 | 255 | 251 | 256 | 263 | 241 | 242 |
| 7 | 206 | 173 | 197 | 194 | 201 | 167 | 211 | 179 | 183 | 209 | 166 | 178 | 203 | 180 | 163 | 185 | 169 | 171 | 184 | 189 |
| 8 | 150 | 125 | 113 | 156 | 130 | 126 | 158 | 114 | 148 | 141 | 144 | 120 | 153 | 154 | 146 | 157 | 122 | 137 | 123 | 129 |
| 9 | 63 | 104 | 64 | 72 | 81 | 58 | 105 | 85 | 89 | 67 | 82 | 79 | 69 | 71 | 60 | 94 | 66 | 61 | 62 | 83 |
| 10 | 15 | 20 | 9 | 12 | 16 | 39 | 52 | 34 | 10 | 31 | 6 | 8 | 46 | 26 | 17 | 5 | 42 | 3 | 4 | 23 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 523 | 516 | 502 | 527 | 524 | 518 | 506 | 482 | 487 | 497 | 517 | 504 | 477 |
| 2 | 448 | 475 | 433 | 463 | 434 | 432 | 441 | 427 | 437 | 445 | 462 | 465 | 424 |
| 3 | 384 | 389 | 400 | 403 | 399 | 422 | 409 | 391 | 415 | 383 | 408 | 410 | 371 |
| 4 | 319 | 348 | 370 | 341 | 319 | 348 | 370 | 341 | 319 | 343 | 370 | 341 | 318 |
| 5 | 281 | 313 | 303 | 273 | 289 | 284 | 269 | 277 | 301 | 267 | 271 | 283 | 265 |
| 6 | 254 | 239 | 218 | 231 | 228 | 245 | 237 | 247 | 261 | 217 | 219 | 243 | 212 |
| 7 | 195 | 101 | 196 | 161 | 172 | 164 | 165 | 198 | 174 | 177 | 170 | 204 | 159 |
| 8 | 134 | 147 | 149 | 133 | 155 | 138 | 115 | 140 | 152 | 109 | 135 | 139 | 106 |
| 9 | 100 | 86 | 57 | 84 | 68 | 103 | 96 | 55 | 95 | 87 | 78 | 101 | 53 |
| 10 | 13 | 35 | 29 | 21 | 28 | 2 | 38 | 33 | 44 | 41 | 37 | 14 | 0 |

EP 1 841 076 A1

# FIG.19

**European Patent Office**

**EUROPEAN SEARCH REPORT**

Application Number

EP 07 01 4100

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TSGR1: "TS 25.212 V1.0.0" 3GPP, April 1999 (1999-04), pages 1-38, XP002333019 * page 15 - page 16 * ----- | 1,6 | INV. H03M13/23 H03M13/27 H03M13/29 H03M13/45 |
| A | DOLINAR S ET AL: "WEIGHT DISTRIBUTIONS FOR TURBO CODES USING RANDOM AND NONRANDOM PERMUTATIONS" JET PROPULSION LAB PROGRESS REPORT, 15 August 1995 (1995-08-15), pages 56-65, XP000863600 * page 62 * ----- | 1,6 | |

|  |  |  | TECHNICAL FIELDS SEARCHED (IPC) |
|---|---|---|---|
|  |  |  | H03M |

The present search report has been drawn up for all claims

| Place of search | Date of completion of the search | Examiner |
|---|---|---|
| The Hague | 20 August 2007 | Van Staveren, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)